(19) Europäisches Patentamt
European Patent Office
Office européen des brevets

(11) **EP 1 511 363 A1**

(12) **EUROPEAN PATENT APPLICATION**
published in accordance with Art. 158(3) EPC

(43) Date of publication:
**02.03.2005 Bulletin 2005/09**

(21) Application number: **02730838.6**

(22) Date of filing: **31.05.2002**

(51) Int Cl.[7]: **H05B 33/14**, H05B 33/22

(86) International application number:
**PCT/JP2002/005366**

(87) International publication number:
**WO 2003/088721 (23.10.2003 Gazette 2003/43)**

(84) Designated Contracting States:
**AT BE CH CY DE DK ES FI FR GB GR IE IT LI LU MC NL PT SE TR**

(30) Priority: **15.04.2002 JP 2002111659**
**14.05.2002 JP 2002138212**

(71) Applicant: **Sony Corporation**
**Tokyo 141-0001 (JP)**

(72) Inventors:
- **ISHIBASHI, Tadashi, SONY CORPORATION Tokyo 141-0001 (JP)**
- **TAMURA, Shinichiro, SONY CORPORATION Tokyo 141-0001 (JP)**
- **UEDA, Naoyuki, SONY CORPORATION Tokyo 141-0001 (JP)**
- **ICHIMURA, Mari, SONY CORPORATION Tokyo 141-0001 (JP)**
- **YAMADA, Jiro, SONY CORPORATION Tokyo 141-0001 (JP)**

(74) Representative: **Müller, Frithjof E., Dipl.-Ing.**
**Müller Hoffmann & Partner**
**Patentanwälte**
**Innere Wiener Strasse 17**
**81667 München (DE)**

# (54) ORGANIC FIELD EMISSION DEVICE AND EMISSION DEVICE

(57) The present invention provides an organic electroluminescence light emitting device capable of preventing a color (hue) of light and a luminous efficiency from being varied depending on a concentration of a luminous material contained in a light emission layer and an operational condition such as an applied voltage, thereby exhibiting a high luminance, a high performance, and a stable, high reliability. The light emitting device includes an anode (6), a hole transport layer (2), a light emission layer (3), an electron transport layer (4), or includes an anode (6), a hole transport layer (2), and a light emission layer (4) serving as an electron transport layer. A light emission region is formed by a mixed layer made from a luminescent material and a charge injection accelerating material. The luminescent material exhibits, in a state held as a single thin film between the anode (6) and the cathode (7), electroluminescence light emission when a DC voltage is applied thereto and has a charge transport characteristic. The charge injection accelerating material is different from the luminous material and has a charge transport characteristic capable of accelerating injection of charges in the luminescent material. The light emission region exists not only at an interface with an adjacent layer or its vicinity but also over a specific thickness region in the layer thickness direction.

FIG. 14

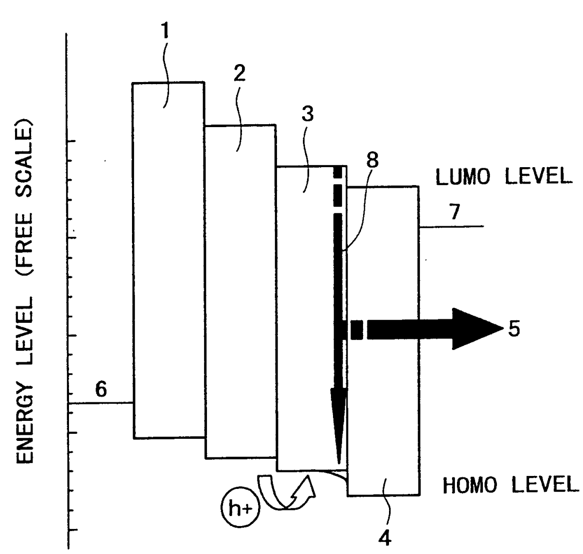


EP 1 511 363 A1

## Description

TECHNICAL FIELD

The present invention relates to an organic electroluminescence light emitting device (organic EL device) including an organic layer having a light emitting region between an anode and a cathode, and to a light emitting apparatus, such as a display device, using the same.

BACKGROUND ART

Displays have a major role in our daily living, for example, in the forms of television receivers, computer monitors, and portable information terminals. With advance of the Internet, displays as human interfaces have become increasingly important. These displays have been required to have a screen being comfortable for eyes to see and ensuring a definition high enough to allow clear viewing, and to have a resolution and a responsiveness high enough to allow clear, clean viewing of moving pictures without delay.

Organic EL devices using organic compounds as luminescent materials exhibit a wide viewing angle, a high contrast, and an excellent visibility. Another advantage of organic EL devices is that since the devices emit spontaneous light, they do not require any backlight unlike liquid crystal, to thereby realize thinning of the size and reduction in weight, and also realize reduction in power consumption.

Organic EL devices using organic compounds as luminescent materials are further advantageous in that they are operable with a low DC voltage at a high response speed, have a resistance against vibration, and are usable in a wide range of temperatures. Organic EL devices, therefore, have become a focus of attention as the next generation display devices, and some of them have already begun to be put into market.

Organic electroluminescence light emitting devices using organic luminescent materials have a configuration that an organic electroluminescence layer containing an organic luminescent material is sandwiched between an anode and a cathode, wherein at least one of the anode and the cathode has a light permeability. In these devices, light emission occurs when a DC voltage is applied between the anode and the cathode.

FIGS. 10 and 12 show examples of related art organic electroluminescence light emitting devices (organic EL devices).

FIG. 10 shows a related art organic electroluminescence light emitting device having a single-hetero structure, wherein an anode 6 made from a light permeable ITO (Indium Tin Oxide) or the like, an organic layer 15a composed of a hole transport layer 2 and an electron transport layer 4, and a cathode 7 are sequentially stacked on a substrate 10 made from light permeable glass or the like, and the stacked structure thus formed on the substrate 10 is sealed with a protective layer 14. In this device, when a DC voltage supplied from a power source 20 is applied between the anode 6 and the cathode 7, light 5 having a specific wavelength is emitted from an interface between the hole transport layer 2 and the electron transport layer 4.

FIG. 11 shows another organic electroluminescence light emitting device having a double-hetero structure, wherein a light permeable anode 6, an organic layer 15b composed of a hole injection layer 1, a hole transport layer 2, a light emission layer 3, and an electron transport layer 4, and a cathode 7 are sequentially stacked on a light permeable substrate 10, and the stacked structure formed on the substrate 10 is sealed with a protective layer 14. It is to be noted that the hole injection layer is not necessarily provided. In this case, when a DC voltage supplied from a power source 20 is applied between the anode 6 and the cathode 7, holes injected from the anode 6 reach the light emission layer 3 via the hole transport layer 2, and electrons injected from the cathode 7 reach the light emission layer 3 via the electron transport layer 4. As a result, hole-electron recombination occurs in the light emission layer 3, to produce single exciton, from which light 5 having a specific wavelength is emitted.

FIG. 12 is a view showing a configuration of a flat display using the above-described organic electroluminescence light emitting device. As shown in this figure, for a full-color display, an organic layer 15 (15a, 15b) allowing emission of light of three primary colors of red (R), green (G), and blue (B) is disposed between a cathode 7 and an anode 6. In general, the cathode 7 is composed of cathode stripes 7, and the anode 6 is composed of anode stripes 6, wherein the cathode stripes 7 and the anode stripes 6 are arranged to cross each other. A signal voltage is selectively applied from a luminance signal circuit 24 to one of the cathode stripes 7 and a signal voltage is selectively applied from a shift register integrated control circuit 25 to one of the anode stripes 6, whereby a portion (pixel) of the organic layer, located at a position where the selected cathode stripe 7 and the selected anode stripe 6 cross each other, emits light.

The light emission layer can be made from one kind or two or more kinds of materials selected from various materials. As one example of a device structure, for example, of a type shown in FIG. 10, characterized by including a light emission layer made from two or more kinds of materials, a two-layer structure having an electron transport layer 4 containing a luminescent material so as to serve as a light emission layer and a hole transport layer 2 has been

reported by C. W. Tang, S. A. VanSlyke, and C. H. Chen in J. of Appl. Phys. 65-9, 3610-3616 (1989). This device structure has been also disclosed in Japanese Patent Laid-open No. Sho 63-264692.

This known technique is intended to provide an electroluminescence light emitting device capable of obtaining an optical output in a wider wavelength range at a lower applied voltage and exhibiting a high stability. In this device, as a mean for realizing such characteristics, a light emission layer is composed of an organic host material capable of sustaining injection of both holes and electrons, and a fluorescent material capable of emitting light in response to hole-electron recombination.

The hue of light emitted from the light emission layer is modified by doping a slight amount of such a fluorescent material in the light emission layer. The minimum amount, being enough to achieve the above-described effect, of the fluorescent material varies depending on specific selection of the host material and the fluorescent material; however, according to the above-described known technique, it is described in the specification of the patent document that in any case, it is not required to use the fluorescent material in an amount of about 10 mole percent or more on the basis of the mole number of the host material, and more specifically, it is seldom required to use the fluorescent material in an amount of 1 mole percent or more.

In the specification of the patent document, a hue as a function of a concentration of a fluorescent material is shown in Table II which summarizes the results of Examples 7-13. In this table, it is shown that assuming that a luminous efficiency of an EL device including a light emission layer containing no fluorescent material is taken as 1.0, a luminous efficiency of the same EL device as that described above except that the light emission layer containing 4.4 mole percent of a fluorescent material exemplified by 4-(dicyanomethylene)-2-methyl-6-[2-(9-julolidyl)ethenyl]-4H-thiopyran is reduced to 0.14. It is also shown that the emission wavelength (535 nm) of the EL device including the light emission layer containing no fluorescent material becomes longer with the increase in concentration of the fluorescent material, and the emission wavelength of the EL device reaches 690 nm when the concentration of the fluorescent material is 4 mole percent.

As compared with an EL device including a light emission layer made from a single luminescent material, the EL device produced by the above-described cited technique has some advantages. One of the advantages is to easily change the emission wavelength. For the EL device including the light emission layer made from a single luminescent material, in order to change the emission color, it is required to change a chemical structure of the luminescent material, and therefore, in order to introduce each substitutional group for changing the emission wavelength, it is required to synthesize a new material. On the contrary, according to the known technique, the emission wavelength can be changed by doping a slight amount of a fluorescent material in the host material. Another advantage is that a fluorescent material having neither film formability nor charge transport characteristic can be used.

The known technique, however, has important problems from the viewpoint of practical use. One of the problems is that since the hue and the luminous efficiency are greatly varied depending on a variation in concentration of the fluorescent material as described in the specification of the patent document, it is difficult to perform quality control for keeping the characteristics in the production process. Another problem is that since the hue is varied depending on an applied voltage or current, it is difficult to stably control the hue in the case where the device is applied as an element of a display.

In the device having the structure shown in FIG. 10 or 11, holes and electrons are concentrated at an interface between the organic layers 2 and 4 or its vicinity, or concentrated at an interface between the organic layers 2 and 3 and its vicinity, or an interface between the organic layers 3 and 4 and its vicinity, and consequently, light emission occurs at the interface or its vicinity, causing deterioration of the device, thereby shortening the service life of the device. In other words, the device having the above structure is poor in reliability. To be more specific, for the device having the structure shown in FIG. 11, if the light emission layer 3 is made from a single material having an electron transport characteristic, as shown in FIG. 13 illustrating energy levels of the layers constituting the device, a region (light emission region) in which hole-electron recombination efficiently occurs is concentrated in the vicinity of an interface, adjacent to a hole transport layer, of the light emission layer; and if the light emission layer 3 is made from a single material having a hole transport characteristic, as shown in FIG. 14 illustrating energy levels of layers constituting the device, a light emission region is concentrated in the vicinity of an interface, adjacent to an electron transport layer, of the light emission layer.

Taking into account the above-described technical background, the present invention has been made, and an object of the present invention is to provide an organic electroluminescence light emitting device capable of preventing a color (hue) of light and a luminous efficiency from being varied depending on a concentration of a luminous material contained in a light emission layer and an operational condition such as an applied voltage, thereby exhibiting a high luminance, a high performance, and a stable, high reliability.

DISCLOSURE OF INVENTION

The present invention has been made to provide a new, effective configuration of a light emission layer in

order to achieve the above object, and according to the present invention, there is provided an organic electroluminescence light emitting device, in which an organic layer having a light emission region is provided between an anode and a cathode, characterized in that at least one of layers constituting the organic layer is composed of a mixed layer made from a luminescent material and a charge injection accelerating material, wherein the luminescent material exhibits, in a state held as a single thin film between the anode and the cathode, electroluminescence light emission when a voltage is applied thereto and has a charge transport characteristic, and the charge injection accelerating material has a charge transport characteristic capable of accelerating injection of charges in the luminescent material; and the at least one of layers constituting the organic layer has a light emission region existing not only at an interface with an adjacent layer or its vicinity but also over a specific thickness region from the interface or its vicinity in the layer thickness direction. The present invention also provides a light emitting apparatus using such an organic electroluminescence light emitting device.

The organic electroluminescence light emitting device of the present invention typically includes an anode, a hole transport layer, a light emission layer, an electron transport layer, or includes an anode, a hole transport layer, and a light emission layer serving as an electron transport layer. A light emission region of the device is formed by a mixed layer made from a luminescent material and a charge injection accelerating material. The luminescent material exhibits, in a state held as a single thin film between the anode and the cathode, electroluminescence light emission when a DC voltage is applied thereto and has a charge transport characteristic. The charge injection accelerating material is different from the luminous material and has a charge transport characteristic capable of accelerating injection of charges in the luminescent material. The light emission region exists not only at an interface with an adjacent layer or its vicinity but also over a specific thickness region in the layer thickness direction. Accordingly, a region in which light is emitted is not limited to the above-described interface or its vicinity but can be spread in a wide range of the light emission layer. This means that even if the performance of a portion located in the layer thickness direction is deteriorated, light emission occurs a portion above or below the deteriorated portion, so that light emission occurs substantially over a specific thickness region in the light emission layer. As a result, it is possible to significantly improve the service life of the device.

The luminous material used for the above-described known technique (Japanese Patent Laid-open No. Sho 63-264692) exhibits light emission resulting from fluorescence. On the other hand, the luminous material used for the present invention exhibits, in a state held as a single thin film between an anode and a cathode, electroluminescence light emission by itself when a DC voltage is applied thereto. In other words, the luminous material used for the present invention has not only electroluminescence light emission characteristic but also a charge transport characteristic, and therefore, does not require a material equivalent to the host material (used in the known technique) for keeping injection of holes and electrons in the light emission layer, and further the luminous material does not emit light in response to hole-electron recombination but emits light by performing hole-electron recombination by itself. Accordingly, a hue and a luminous efficiency of the device of the present invention is not varied so much depending on a concentration of the luminous material, with a result that the device of the present invention can obtain a stable hue.

BRIEF DESCRIPTION OF DRAWINGS

FIG. 1 is a diagram showing an energy level of each layer and a mechanism of light emission for an organic electroluminescence light emitting device of the present invention;

FIG. 2 is a schematic diagram showing an energy level of each layer and a mechanism of light emission for another organic electroluminescence light emitting device of the present invention;

FIG. 3 is a schematic diagram showing an energy level of each layer and a mechanism of light emission for a further organic electroluminescence light emitting device of the present invention;

FIG. 4 is a schematic diagram showing an energy level of each layer and a mechanism of light emission for still a further organic electroluminescence light emitting device of the present invention;

FIG. 5 is a diagram showing an emission spectrum of a comparative organic electroluminescence light emitting device;

FIG. 6 is a diagram showing an emission spectrum of an organic electroluminescence light emitting device of the present invention;

FIG. 7 is a schematic sectional view of an organic electroluminescence light emitting device used for measuring a light emission region;

FIG. 8 is a spectral diagram showing a relationship between an actually measured emission spectrum and an emission spectrum estimated from a light emission distribution in a light emission layer;

FIG. 9 is a spectral diagram showing a light emission distribution in a light emission layer;

FIG. 10 is a schematic sectional view of an essential portion of a related art organic electroluminescence light

emitting device;

FIG. 11 is a schematic sectional view of an essential portion of another related art organic electroluminescence light emitting device;

FIG. 12 is a view showing a configuration of a full-color flat display using related art organic electroluminescence light emitting devices;

FIG. 13 is a schematic diagram showing an energy level of each layer and a mechanism of light emission for a related art organic electroluminescence light emitting device; and

FIG. 14 is a schematic diagram showing an energy level of each layer and a mechanism of light emission for another related art organic electroluminescence light emitting device.

## BEST MODE FOR CARRYING OUT THE INVENTION

According to the present invention, the above-described thickness region is preferably specified such that on the basis of an intensity of light emitted from each or both of an interface between the mixed layer and an electron transport layer adjacent thereto and an interface between the mixed layer and a hole transport layer adjacent thereto, an intensity of light emitted from a position being equidistant from the both interfaces is in a range of 25% or more.

A concentration range of the luminous material on the basis of a mole number of the charge injection accelerating material having a charge transport characteristic capable of accelerating injection of charges in the luminous material in the light emission layer is preferably in a range of 5 to 90 mole percent (about 5 to 90 wt%), more preferably, in a range of 10 to 90 mole percent (about 10 to 90 wt%).

On the contrary, according to the above-described known technique (Japanese Patent Laid-open No. Sho 63-264692), it is described that the minimum ratio of the fluorescent material is varied depending on the specific selection of the host material and the fluorescent material; however, in any case, it is not required to use the fluorescent material in an amount of about 10 mole percent or more on the basis of the mole number of the host material, and more specifically, it is seldom required to use the fluorescent material in an amount of 1 mole percent or more. Therefore, the ratio of the fluorescent material is substantially not overlapped to the preferred concentration range of the luminous material used for the present invention. Further, according to the present invention, a hue of light is not varied depending on a change in the applicable concentration of the luminous material. This is basically different from the known technique intended to positively change a hue of light by changing the concentration of the fluorescent material.

The charge injection accelerating material having a charge transport characteristic capable of accelerating injection of charges in the light emission layer for acceleration light emission due to hole-electron recombination in the luminous material is preferably specified as follows: (1) an energy level of a lowest unoccupied molecular orbital (LUMO) of the charge injection accelerating material is equal to or smaller (shallower) than that of the luminous material, or an energy level of a highest occupied molecular orbital (HOMO) of the charge injection accelerating material is equal to or larger (deeper) than that of the luminous material; or (2) the energy level of the lowest unoccupied molecular orbital (LUMO) of the charge injection accelerating material is equal to or smaller (shallower) than that of the luminous material, and the energy level of the highest occupied molecular orbital (HOMO) of the charge injection accelerating material is equal to or larger (deeper) than that of the luminous material.

If the above energy condition (1) is satisfied, the same material as a material forming the electron transport layer can be used as a material having the charge transport characteristic capable of accelerating injection of charges in the luminous material, and the same material as a material forming the hole transport layer can be used as a material having the charge transport characteristic capable of injection of charges in the luminous material. If the above energy condition (2) is satisfied, both the same material as a material forming the electron transport layer and the same material as a material forming the hole transport layer can be used as the material having the charge transport characteristic capable of accelerating injection of charges in the luminous material. Further, an energy level of the lowest unoccupied molecular orbital (LUMO) of the hole transport layer adjacent to the mixed layer may be shallower than that of each of the luminous material and the charge injection accelerating material.

The organic electroluminescence light emitting device of the present invention does not make use of a mechanism that either or both of electrons injected from the cathode and holes injected from the anode are concentrated at the interface between the organic layers, to cause hole-electron recombination, resulting in light emission, but make use of a mechanism that the luminous material efficiently acts as a trap for electrons and holes in the material having the charge transport characteristic in the light emission layer, to cause hole-electron recombination in the luminous material, resulting in light emission. The organic electroluminescence light emitting device of the present invention is thus characterized in that the light emission region is not concentrated in the vicinity of the interface between the organic layers but can exist over a wide range in the light emission layer, so that as compared with the case where a luminous material singly exists in a light emission layer, it is possible to significantly improve the reliability of the device. This means that according to the light emitting device of the present invention, it is possible to prevent occurrence of an inconvenience that the concentrated charge density in a light emission layer of a device accelerates deterioration of

the device.

In the case (A) where a light emission layer 3 is made from a single material and the material has an electron transport characteristic as shown in FIG. 13, a region (light emission region) in which recombination 8 of holes and electrons efficiently occurs is concentrated in the vicinity of an interface of a portion in the light emission layer 3 with a hole transport layer 2. Meanwhile, in the case (B) where a light emission layer 3 is made from a single material and the material has a hole transport characteristic as shown in FIG. 14, a light emission region is concentrated in the vicinity of an interface of a portion in the light emission layer 3 with an electron transport layer 4.

On the contrary, according to the present invention, in the case (C) where a light emission layer is formed by mixing a luminous material having an electron transport characteristic in a charge injection accelerating material 18 having an electron transport characteristic as shown in FIG. 1 and in the case (D) where a light emission layer is formed by mixing a luminous material having a hole transport characteristic in a charge injection accelerating material 18 having a hole transport characteristic as shown in FIG. 2, a region (light emission region) in which recombination 19 of holes and electrons efficiently occurs is somewhat spread inwardly from the interface into the light emission layer (within a specific thickness region in the layer thickness direction). Further, in the case (E) where a light emission layer is formed by mixing a luminous material having a hole transport characteristic in a charge injection accelerating material 18 having an electron transport characteristic as shown in FIG. 3 and in the case (F) where a light emission layer is formed by mixing a luminous material having an electron transport characteristic in a charge injection accelerating material 18 having a hole transport characteristic as shown in FIG. 4, the density of electrons and holes is not concentrated only in the vicinity of an interface between the organic layers but is widely dispersed in the light emission layer (within a further enlarged thickness region), so that recombination 19 of holes and electrons occurs in the wide range dispersed in the light emission layer. Accordingly, deterioration of the device does not occur at a concentrated portion in the light emission layer but occurs in a wide range in the light emission layer, with a result that the service life of the device is prolonged and thereby the reliability of the device is enhanced.

The distribution of a light emission region in the light emission layer is varied depending on a voltage and a current applied to the device and a luminance; however, at an effective available luminance necessary for a display or the like using the device, the light emission region in the light emission layer is preferably specified such that on the basis of an intensity of light emitted from each or both of an interface between the mixed layer and an electron transport layer adjacent thereto and an interface between the mixed layer and a hole transport layer adjacent thereto, an intensity of light emitted from a position being equidistant from the both interfaces, that is, from a central portion of the light emission layer is in a range of 25% or more. By making effective use of the whole region of the light emission layer as the light emission region as described above, the reliability of the device can be significantly improved.

To improve the reliability of the device by not concentrating the light emission region only in the vicinity of the interface but widely dispersing the light emission region in the light emission layer as described above, in the above-described case (E), the charge injection accelerating material may have not only the electron transport characteristic but also the hole transport characteristic, and the luminous material may have not only the hole transport characteristic but also the electron transport characteristic. Further, in the above-described case (F), the charge injecting accelerating material may have not only the hole transport characteristic but also the electron transport characteristic, and the luminous material may have not only the electron transport characteristic but also the hole transport characteristic.

In addition, the organic electroluminescence light emitting device of the present invention may be used as at least part of each of pixels of a display.

Hereinafter, preferred embodiments of the present invention will be described in detail with reference to the drawings.

First, examples of device structures to each of which the organic electroluminescence light emitting device of the present invention is applied. FIG. 10 shows the above-described device structure including the anode 6, the hole transport layer 2, the light emission layer 4 serving as an electron transport layer, and the cathode 7, and FIG. 11 shows the above-described device structure including the anode 6, the hole injection layer 1 (provided as needed), the hole transport layer 2, the light emission layer 3, the electron transport layer 4, and the cathode 7. The organic electroluminescence light emitting device of the present invention is applicable to each of these device structures; however, as shown in FIGS. 1 to 4, according to the present invention, a charge (electron or hole) injection accelerating material is mixed in the light emission layer. When a voltage is applied between the anode 6 and the cathode 7 of the device having the above device structure, a current flows therebetween, to allow light emission from the light emission layer of the device.

A substrate 10 for supporting the organic electroluminescence light emitting device is in contact with the anode 6 or the cathode 7. A light permeable substrate made from glass, quartz, or plastic, a substrate having no light permeability in a visible light region such as silicon, or a substrate on the surface of which a thin film transistor circuit is formed is used in accordance with an application of the device.

Light emitted from the light emission layer 4 serving as an electron transport layer or the light emission layer 3 can be emerged to the outside by giving light permeability to at least one of the anode 6 and the cathode 7. The

anode 6 may be made from ITO (Indium Tin Oxide), a metal such as $SnO_2$, Cr, Pd, In, Au, W, or Ni, or an alloy containing one of the metals. The cathode 7 may be made from an active metal such as Li, Mg or Ca, or an alloy containing Ag, Al, or In and one of the active metals. In addition, the cathode 7 may be of a stacked structure of these metal or alloy layers. It is to be noted that the above materials for the anode 6 and the cathode 7 are only for illustrative purposes only, and it is to be understood that other materials may be used in accordance with an application of the device. Further, to improve the service life of the organic electroluminescence light emitting device, the device may be provided with a means for cutting off permeation of water or oxygen from external.

The hole injection layer 1 for accelerating injection of holes may be provided between the anode 6 and the hole transport layer 2. The hole injection layer 1 may be made from, for example, a porphyrin compound described in U.S. Patent No. 4,720,432. To facilitate injection of holes to the light emission layer serving as an electron transport layer or the light emission layer, the hole transport may be of not a single layer but a stacked structure. Each of the electron transport layer and the hole transport layer may be made from a material suitably selected from known materials. To facilitate injection of electrons from the cathode 7 to the light emission layer serving as an electron transport layer and the electron transport layer, a thin film made from LiF or $LiO_2$ may be inserted. Further, a hole block layer for preventing injection of holes from the light emission layer to the electron transport layer may be provided.

As a useful example of a luminous material contained in the light emission layer, there is known a material having, in its molecular skeleton, a styryl or distyryl structure described in Japanese Patent Laid-open Nos. Hei 11-329730, Hei 11-329731, 2000-91076, 2000-173773, 2000-12224, 2000-12225, 2000-12226, 2000-12227, 2000-12228, 2000-91073, 2000-91074, 2000-91075, 2000-173774, 2001-110570, and 2001-110571. Such a material can satisfy the prerequisite of the present invention that it has formability of an amorphous thin film and exhibits, in a state held as a single thin film between the anode and the cathode, electroluminescence light emission when a DC voltage is applied thereto.

As a material having a charge transport characteristic (charge injection accelerating material) capable of accelerating injection of charges in the luminous material, there may be used a material suitably selected from known electron transport materials and hole transport materials.

The present invention will be hereinafter described in detail by way of, while not limited thereto, the following examples.

Example 1 (Concentration of Compound 1 and Luminous Efficiency)

In this example, organic electroluminescence light emitting devices, each using, as a light emission layer having an electron transport characteristic, a mixed layer made from a styryl compound represented by a compound 1 described below and an electron transport material represented by $Alq_3$ (tris (8-quinolinol) aluminum) described below, are produced as samples, and a relationship between a luminance of light emitted from each sample and a luminous efficiency of the sample is examined.

Samples of organic electroluminescence light emitting devices were prepared as follows: namely, as a light emission layer of each organic electroluminescence light emitting device, a mixed layer made from a styryl compound 1 expressed by the following chemical formula, and an electron transport material $Alq_3$ expressed by the following chemical formula was formed by a vacuum vapor-deposition process; and as the other components of this light emitting device, a glass sheet was used as a substrate, and an anode made from ITO, a hole transport layer made from α-NPD expressed by the following chemical formula, and a cathode made from Mg-Ag were each formed by a known process. Device structures of the samples thus prepared are shown below. It is to be noted that in each device structure, a value in the parenthesis expresses a film thickness (the same applies in the later examples).

[Compound 1]

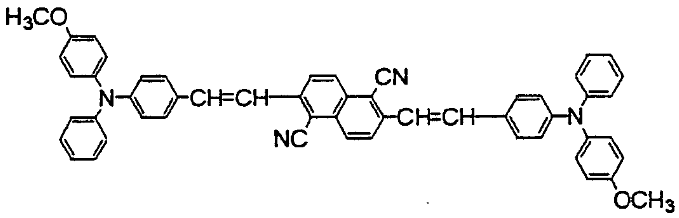

[Alq3] :

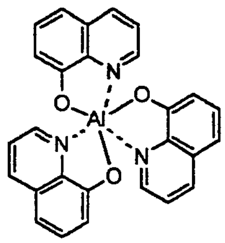

[α-NPD] :

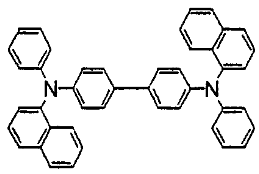

[Device Structure]:

Device (1-1):
ITO/α-NPD [30 nm]/compound 1:$Alq_3$ = 1:9 [30 nm]/$Alq_3$ [30 nm]/Mg:Ag [200 nm]
Device (1-2):
ITO/α-NPD [30 nm]/compound 1:$Alq_3$ = 3:7 [30 nm]/$Alq_3$ [30 nm]/Mg:Ag [200 nm]
Device (1-3):
ITO/α-NPD [30 =]/compound 1:$Alq_3$ = 5:5 [30 nm] /$Alq_3$ [30 nm]/Mg:Ag [200 nm]
Device (1-4):
ITO/α-NPD [30 nm]/compound 1:$Alq_3$ = 8:2 [30 nm]/$Alq_3$ [30 nm]/Mg:Ag [200 nm]
Device (1-5):
ITO/α-NPD [30 nm]/compound 1:$Alq_3$ = 9:1 [30 nm]/$Alq_3$ [30 nm]/Mg:Ag [200 nm]

A relationship between a luminance and a luminous efficiency of each of the sample Nos. Device (1-1), Device (1-2), Device (1-3), Device (1-4), and Device (1-5) is shown in Table 1. It is to be noted that the luminous efficiency is calculated as a rate of luminance to a current value.

Table 1

| (Relationship between Concentration of Compound 1 in Light Emission Layer and Luminous Efficiency) | | | | | |
|---|---|---|---|---|---|
| | Concentration of Compound 1 in Light Emission Layer | 1 cd/$m^2$ | 10 cd/$m^2$ | 100 cd/$m^2$ | 1000 cd/$m^2$ |
| Device (1-1) | 10 wt% | 2.35 cd/A | 2.36 cd/A | 2.30 cd/A | 2.24 cd/A |
| Device (1-2) | 30 wt% | 2.33 cd/A | 2.34 cd/A | 2.23 cd/A | 2.09 cd/A |
| Device (1-3) | 50 wt% | 2.33 cd/A | 2.33 cd/A | 2.32 cd/A | 2.12 cd/A |
| Device (1-4) | 80 wt% | 2.32 cd/A | 2.33 cd/A | 2.31 cd/A | 2.11 cd/A |
| Device (1-5) | 90 wt% | 2.31 cd/A | 2.33 cd/A | 2.30 cd/A | 2.12 cd/A |

The results show that the luminous efficiency of each of the sample Nos. Device (1-1), Device (1-2), Device (1-3), Device (1-4), and Device (1-5) is high and stable irrespective of the concentration of the luminescent material in a practical luminance region from 1 to 1000 cd/$m^2$, and that each of the samples has no problem associated with concentration-dependent quenching caused when a high concentration of the luminous material is contained in the light emitting device.

Example 2 (Concentration of Compound 1 and Luminous Efficiency)

In this example, organic electroluminescence light emitting devices, each using, as a light emission layer having a hole transport characteristic, a mixed layer made from the same styryl compound 1 as that described in Example 1 and the same hole transport material α-NPD as that described in Example 1, are produced as samples, and a relationship between a luminance of light emitted from each sample and a luminous efficiency of the sample is examined.

Samples of organic electroluminescence light emitting devices were prepared in the same manner as that described in Example 1, except that a mixed layer made from the same styryl compound 1 as that described in Example 1 and the same hole transport material α-NPD as that described in Example 1 was formed as a light emission layer by a vacuum vapor-deposition process.

[Device Structure]:

Device (2-1):
ITO/α-NPD [30 nm]/compound 1:α-NPD = 1:9 [30 nm]/$Alq_3$ [30 nm]/Mg:Ag [200 nm]
Device (2-2):
ITO/α-NPD [30 nm]/compound 1:α-NPD = 3:7 [30 nm]/$Alq_3$ [30 nm]/Mg:Ag [200 nm]
Device (2-3):
ITO/α-NPD [30 nm]/compound 1:α-NPD = 5:5 [30 nm]/$Alq_3$ [30 nm]/Mg:Ag [200 nm]
Device (2-4):
ITO/α-NPD [30 nm]/compound 1:α-NPD = 8:2 [30 nm]/$Alq_3$ [30 nm]/Mg:Ag [200 nm]
Device (2-5):
ITO/α-NPD [30 nm]/compound 1:α-NPD = 9:1 [30 nm]/$Alq_3$ [30 nm]/Mg:Ag [200 nm]

A relationship between a luminance and a luminous efficiency of each of the sample Nos. Device (2-1), Device (2-2), Device (2-3), Device (2-4), and Device (2-5) is shown in Table 2. It is to be noted that the luminous efficiency is calculated as a rate of luminance to a current value.

Table 2

(Relationship between Concentration of Compound 1 in Light Emission Layer and Luminous Efficiency)

| | Concentration of Compound 1 in Light Emission Layer | 1 cd/$m^2$ | 10 cd/$m^2$ | 100 cd/$m^2$ | 1000 cd/$m^2$ |
|---|---|---|---|---|---|
| Device (2-1) | 10 wt% | 2.22 cd/A | 2.24 cd/A | 2.30 cd/A | 2.13 cd/A |
| Device (2-2) | 30 wt% | 2.12 cd/A | 2.15 cd/A | 2.11 cd/A | 2.07 cd/A |
| Device (2-3) | 50 wt% | 2.11 cd/A | 2.12 cd/A | 2.1 cd/A | 2.05 cd/A |
| Device (2-4) | 80 wt% | 2.09 cd/A | 2.1 cd/A | 2.08 cd/A | 2.01 cd/A |
| Device (2-5) | 90 wt% | 2.1 cd/A | 2.1 cd/A | 2.07 cd/A | 2.03 cd/A |

The results show that the luminous efficiency of each of the sample Nos. Device (2-1), Device (2-2), Device (2-3), Device (2-4), and Device (2-5) is high and stable irrespective of the concentration of the luminescent material in a practical luminance region from 1 to 1000 cd/$m^2$, and that each of the samples has no problem associated with concentration-dependent quenching caused when a high concentration of the luminous material is contained in the light emitting device.

Example 3 (Concentration of Compound 2 and Luminous Efficiency)

In this example, organic electroluminescence light emitting devices, each using, as a light emission layer having an electron transport characteristic, a mixed layer made from a styryl compound represented by a compound 2 described below and the same electron transport material $Alq_3$ (tris (8-quinolinol) aluminum) as that described in Example 1, are produced as samples, and a relationship between a luminance of light emitted from each sample and a luminous efficiency of the sample is examined.

Samples of organic electroluminescence light emitting devices were prepared in the same manner as that described in Example 1, except that a mixed layer made from a styryl compound represented by a compound 2 expressed by the following chemical formula and the same electron transport material $Alq_3$ as that described in Example 1 was formed as a light emission layer by a vacuum vapor-deposition process.

[Compound 2]

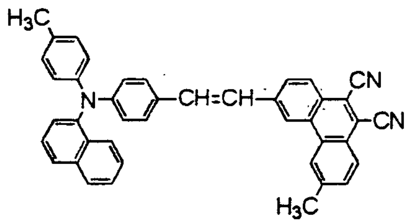

[Device Structure]:

Device (3-1) :
ITO/α-NPD [30 =]/compound 2: $Alq_3$ = 1:9 [30 nm]/$Alq_3$ [30 nm]/Mg:Ag [200 nm]
Device (3-2):
ITO/α-NPD [30 nm]/compound 2: $Alq_3$ = 3:7 [30 nm]/$Alq_3$ [30 nm]/Mg:Ag [200 nm]
Device (3-3):
ITO/α-NPD [30 nm]/compound 2: $Alq_3$ = 5:5 [30 nm]/$Alq_3$ [30 nm]/Mg:Ag [200 nm]
Device (3-4):
ITO/α-NPD [30 nm]/compound 2: $Alq_3$ = 8:2 [30 nm]/$Alq_3$ [30 nm]/Mg:Ag [200 nm]
Device (3-5):
ITO/α-NPD [30 nm]/compound 2: $Alq_3$ = 9:1 [30 nm]/$Alq_3$ [30 nm]/Mg:Ag [200 nm]

A relationship between a luminance and a luminous efficiency of each of the sample Nos. Device (3-1), Device (3-2), Device (3-3), Device (3-4), and Device (3-5) is shown in Table 3. It is to be noted that the luminous efficiency is calculated as a rate of luminance to a current value.

Table 3

| (Relationship between Concentration of Compound 1 in Light Emission Layer and Luminous Efficiency) | | | | | |
|---|---|---|---|---|---|
| | Concentration of Compound 2 in Light Emission Layer | 1 cd/m$^2$ | 10 cd/m$^2$ | 100 cd/m$^2$ | 1000 cd/m$^2$ |
| Device (3-1) | 10 wt% | 2.18 cd/A | 2.16 cd/A | 2.12 cd/A | 2.03 cd/A |
| Device (3-2) | 30 wt% | 2.14 cd/A | 2.13 cd/A | 2.1 cd/A | 2.05 cd/A |
| Device (3-3) | 50 wt% | 2.13 cd/A | 2.12 cd/A | 2.12 cd/A | 2.08 cd/A |
| Device (3-4) | 80 wt% | 2.11 cd/A | 2.12 cd/A | 2.11 cd/A | 2.1 cd/A |
| Device (3-5) | 90 wt% | 2.13 cd/A | 2.11 cd/A | 2.13 cd/A | 2.1 cd/A |

The results show that the luminous efficiency of each of the sample Nos. Device (3-1), Device (3-2), Device (3-3), Device (3-4), and Device (3-5) is high and stable irrespective of the concentration of the luminescent material in a practical luminance region from 1 to 1000 cd/$m^2$, and that each of the samples has no problem associated with concentration-dependent quenching caused when a high concentration of the luminous material is contained in the light emitting device.

Example 4 (Concentration of Compound 2 and Luminous Efficiency)

In this example, organic electroluminescence light emitting devices, each using, as a light emission layer having a hole transport characteristic, a mixed layer made from the same styryl compound 2 as that described in Example 2 and the same hole transport material α-NPD as that described in Example 1, are produced as samples, and a relationship between a luminance of light emitted from each sample and a luminous efficiency of the sample is examined.

Samples of organic electroluminescence light emitting devices were prepared in the same manner as that described in Example 1, except that a mixed layer made from the same styryl compound 2 as that described in Example 2 and the same hole transport material α-NPD as that described in Example 1 was formed as a light emission layer by a vacuum vapor-deposition process.

[Device Structure]:

Device (4-1):
ITO/α-NPD [30 nm]/compound 2:α-NPD = 1:9 [30 nm]/$Alq_3$ [30 nm]/Mg:Ag [200 nm]
Device (4-2):
ITO/α-NPD [30 nm]/compound 2:α-NPD = 3:7 [30 nm]/$Alq_3$ [30 nm]/Mg:Ag [200 nm]
Device (4-3):
ITO/α-NPD [30 nm]/compound 2:α-NPD = 5:5 [30 nm]/$Alq_3$ [30 nm]/Mg:Ag [200 nm]
Device (4-4):
ITO/α-NPD [30 nm]/compound 2:α-NPD = 8:2 [30 nm]/$Alq_3$ [30 nm]/Mg:Ag [200 nm]
Device (4-5):
ITO/α-NPD [30 nm]/compound 2:α-NPD = 9:1 [30 nm]/$Alq_3$ [30 nm]/Mg:Ag [200 nm]

A relationship between a luminance and a luminous efficiency of each of the sample Nos. Device (4-1), Device (4-2), Device (4-3), Device (4-4), and Device (4-5) is shown in Table 4. It is to be noted that the luminous efficiency is calculated as a rate of luminance to a current value.

Table 4

(Relationship between Concentration of Compound 2 in Light Emission Layer and Luminous Efficiency)

| | Concentration of Compound 2 in Light Emission Layer | 1 cd/$m^2$ | 10 cd/$m^2$ | 100 cd/$m^2$ | 1000 cd/$m^2$ |
|---|---|---|---|---|---|
| Device (4-1) | 10 wt% | 2.15 cd/A | 2.12 cd/A | 2.09 cd/A | 2.04 cd/A |
| Device (4-2) | 30 wt% | 2.1 cd/A | 2.09 cd/A | 2.07 cd/A | 2.05 cd/A |
| Device (4-3) | 50 wt% | 2.09 cd/A | 2.07 cd/A | 2.06 cd/A | 2.03 cd/A |
| Device (4-4) | 80 wt% | 2.08 cd/A | 2.09 cd/A | 2.07 cd/A | 2.02 cd/A |
| Device (4-5) | 90 wt% | 2.09 cd/A | 2.08 cd/A | 2.06 cd/A | 2.00 cd/A |

The results show that the luminous efficiency of each of the sample Nos. Device (4-1), Device (4-2), Device (4-3), Device (4-4), and Device (4-5) is high and stable irrespective of the concentration of the luminescent material in a practical luminance region from 1 to 1000 cd/$m^2$, and that each of the samples has no problem associated with concentration-dependent quenching caused when a high concentration of the luminous material is contained in the light emitting device.

Example 5 (Concentration of Compound 1 and Hue)

In this example, organic electroluminescence light emitting devices, each using, as a light emission layer having an electron transport characteristic, a mixed layer made from the same styryl compound 1 as that described in Example 1 and the same electron transport material $Alq_3$ as that described in Example 1, are produced as samples, and a relationship between a luminance of light emitted from each sample and a hue of the light emitted from the sample is examined.

Samples of organic electroluminescence light emitting devices were prepared in the same manner as that described in Example 1. Namely, like Example 1, a mixed layer made from the same styryl compound 1 as that described in Example 1 and the same electron transport material $Alq_3$ as that described in Example 1 was formed as a light emission layer by a vacuum vapor-deposition process. The same sample Nos. Device (1-1), Device (1-2), Device (1-3), Device (1-4), and Device (1-5) as those prepared in Example 1 were thus prepared.

A relationship between a luminance and a hue of each of the samples is shown in Table 5.

Table 5

| (Relationship between Concentration of Compound 1 in Light Emission Layer and Hue) | | | | | |
|---|---|---|---|---|---|
| | Concentration of Compound 1 | 1 cd/m$^2$ | 10 cd/m$^2$ | 100 cd/m$^2$ | 1000 cd/m$^2$ |
| Device (1-1) | 10 wt% | 0.634, 0.365 | 0.633, 0.355 | 0.630, 0.368 | 0.624, 0.375 |
| Device (1-2) | 30 wt% | 0.643, 0.355 | 0.640, 0.359 | 0.638, 0.359 | 0.633, 0.366 |
| Device (1-3) | 50 wt% | 0.642, 0.356 | 0.641, 0.358 | 0.637, 0.360 | 0.631, 0.368 |
| Device (1-4) | 80 wt% | 0.644, 0.354 | 0.642, 0.357 | 0.637, 0.361 | 0.632, 0.367 |
| Device (1-5) | 90 wt% | 0.643, 0.357 | 0.642, 0.358 | 0.637, 0.362 | 0.632, 0.367 |

The results show that the hues of the sample Nos. Device (1-1), Device (1-2), Device (1-3), Device (1-4), and Device (1-5) are nearly equal to each other irrespective of the concentration of the luminescent material in a practical luminance region from 1 to 1000 cd/m$^2$, and that each of the samples has no problem associated with a change in hue upon high luminance, which problem is liable to be caused for a usual red color light emitting device in which a pigment is doped in $Alq_3$ or the like in a concentration as low as 2 to 3 wt% or less.

Example 6 (Concentration of Compound 1 and Hue)

In this example, organic electroluminescence light emitting devices, each using, as a light emission layer having a hole transport characteristic, a mixed layer made from the same styryl compound 1 as that described in Example 2 and the same hole transport material $\alpha$-NPD as that described in Example 2, are produced as samples, and a relationship between a luminance of light emitted from each sample and a hue of the light emitted from the sample is examined.

Samples of organic electroluminescence light emitting devices were prepared in the same manner as that described in Example 2. Namely, like Example 2, a mixed layer made from the same styryl compound 1 as that described in Example 2 and the same hole transport material $\alpha$-NPD as that described in Example 2 was formed as a light emission layer by a vacuum vapor-deposition process. The same sample Nos. Device (2-1), Device (2-2), Device (2-3), Device (2-4), and Device (2-5) as those prepared in Example 2 were thus prepared. A relationship between a luminance and a hue of each of the samples is shown in Table 6.

Table 6

| (Relationship between Concentration of Compound 1 in Light Emission Layer and Hue) | | | | | |
|---|---|---|---|---|---|
| | Concentration of Compound 1 | 1 cd/m$^2$ | 10 cd/m$^2$ | 100 cd/m$^2$ | 1000 cd/m$^2$ |
| Device (2-1) | 10 wt% | 0.623, 0.376 | 0.622, 0.377 | 0.621, 0.378 | 0.620, 0.379 |
| Device (2-2) | 30 wt% | 0.632, 0.368 | 0.631, 0.369 | 0.629, 0.370 | 0.627, 0.372 |
| Device (2-3) | 50 wt% | 0.635, 0.365 | 0.635, 0.364 | 0.633, 0.366 | 0.631, 0.368 |
| Device (2-4) | 80 wt% | 0.635, 0.364 | 0.634, 0.365 | 0.634, 0.366 | 0.632, 0.367 |
| Device (2-5) | 90 wt% | 0.634, 0.365 | 0.634, 0.365 | 0.634, 0.366 | 0.631, 0.368 |

The results show that the hues of the sample Nos. Device (2-1), Device (2-2), Device (2-3), Device (2-4), and Device (2-5) are nearly equal to each other irrespective of the concentration of the luminescent material in a practical luminance region from 1 to 1000 cd/$m^2$, and that each of the samples has no problem associated with a change in hue upon high luminance, which problem is liable to be caused for a usual red color light emitting device in which a pigment is doped in $Alq_3$ or the like in a concentration as low as 2 to 3 wt% or less.

Example 7 (Concentration of Compound 2 and Hue)

In this example, organic electroluminescence light emitting devices, each using, as a light emission layer having an electron transport characteristic, a mixed layer made from the same styryl compound 2 as that described in Example 3 and the same electron transport material $Alq_3$ as that described in Example 3, are produced as samples, and a relationship between a luminance of light emitted from each sample and a hue of the light emitted from the sample is examined.

Samples of organic electroluminescence light emitting devices were prepared in the same manner as that described in Example 3. Namely, like Example 3, a mixed layer made from the same styryl compound 2 as that described in Example 3 and the same electron transport material $Alq_3$ as that described in Example 3 was formed as a light emission layer by a vacuum vapor-deposition process. The same sample Nos. Device (3-1), Device (3-2), Device (3-3), Device (3-4), and Device (3-5) as those prepared in Example 3 were thus prepared. A relationship between a luminance and a hue of each of the samples is shown in Table 7.

Table 7

| (Relationship between Concentration of Compound 2 in Light Emission Layer and Hue) | | | | | |
|---|---|---|---|---|---|
| | Concentration of Compound 2 | 1 cd/$m^2$ | 10 cd/$m^2$ | 100 cd/$m^2$ | 1000 cd/$m^2$ |
| Device (3-1) | 10 wt% | 0.645, 0.354 | 0.644, 0.355 | 0.643, 0.356 | 0.640, 0.359 |
| Device (3-2) | 30 wt% | 0.651, 0.348 | 0.650, 0.349 | 0.648, 0.351 | 0.645, 0.354 |
| Device (3-3) | 50 wt% | 0.652, 0.348 | 0.651, 0.350 | 0.650, 0.349 | 0.645, 0.354 |
| Device (3-4) | 80 wt% | 0.652, 0.347 | 0.653, 0.347 | 0.651, 0.348 | 0.647, 0.352 |
| Device (3-5) | 90 wt% | 0.652, 0.347 | 0.652, 0.347 | 0.651, 0.348 | 0.646, 0.353 |

The results show that the hues of the sample Nos. Device (3-1), Device (3-2), Device (3-3), Device (3-4), and Device (3-5) are nearly equal to each other irrespective of the concentration of the luminescent material in a practical luminance region from 1 to 1000 cd/$m^2$, and that each of the samples has no problem associated with a change in hue upon high luminance, which problem is liable to be caused for a usual red color light emitting device in which a pigment is doped in $Alq_3$ or the like in a concentration as low as 2 to 3 wt% or less.

Example 8 (Concentration of Compound 2 and Hue)

In this example, organic electroluminescence light emitting devices, each using, as a light emission layer having a hole transport characteristic, a mixed layer made from the same styryl compound 2 as that described in Example 4 and the same hole transport material $\alpha$-NPD as that described in Example 4, are produced as samples, and a relationship between a luminance of light emitted from each sample and a hue of the light emitted from the sample is examined.

Samples of organic electroluminescence light emitting devices were prepared in the same manner as that described in Example 4. Namely, like Example 4, a mixed layer made from the same styryl compound 2 as that described in Example 4 and the same hole transport material $\alpha$-NPD as that described in Example 4 was formed as a light emission layer by a vacuum vapor-deposition process. The same sample Nos. Device (4-1), Device (4-2), Device (4-3), Device (4-4), and Device (4-5) as those prepared in Example 4 were thus prepared. A relationship between a luminance and a hue of each of the samples is shown in Table 8.

Table 8

| (Relationship between Concentration of Compound 2 in Light Emission Layer and Hue) | | | | | |
|---|---|---|---|---|---|
| | Concentration of Compound 2 | 1 cd/$m^2$ | 10 cd/$m^2$ | 100 cd/$m^2$ | 1000 cd/$m^2$ |
| Device (4-1) | 10 wt% | 0.635, 0.364 | 0.634, 0.365 | 0.633, 0.366 | 0.630, 0.369 |

Table 8 (continued)

| (Relationship between Concentration of Compound 2 in Light Emission Layer and Hue) | | | | | |
|---|---|---|---|---|---|
| | Concentration of Compound 2 | 1 cd/m$^2$ | 10 cd/m$^2$ | 100 cd/m$^2$ | 1000 cd/m$^2$ |
| Device (4-2) | 30 wt% | 0.643, 0.357 | 0.642, 0.356 | 0.641, 0.358 | 0.638, 0.361 |
| Device (4-3) | 50 wt% | 0.645, 0.355 | 0.644, 0.355 | 0.643, 0.356 | 0.641, 0.358 |
| Device (4-4) | 80 wt% | 0.645, 0.355 | 0.645, 0.354 | 0.644, 0.355 | 0.640, 0.359 |
| Device (4-5) | 90 wt% | 0.645, 0.354 | 0.644, 0.355 | 0.643, 0.356 | 0.641, 0.358 |

The results show that the hues of the sample Nos. Device (4-1), Device (4-2), Device (4-3), Device (4-4), and Device (4-5) are nearly equal to each other irrespective of the concentration of the luminescent material in a practical luminance region from 1 to 1000 cd/m$^2$, and that each of the samples has no problem associated with a change in hue upon high luminance, which problem is liable to be caused for a usual red color light emitting device in which a pigment is doped in $Alq_3$ or the like in a concentration as low as 2 to 3 wt% or less.

Example 9 (Stability of Device (1-3))

In this example, an organic electroluminescence light emitting device using, as a light emission layer having an electron transport characteristic, a mixed layer made from the same styryl compound 1 as that described in Example 1 and the same electron transport material $Alq_3$ as that described in Example 1 is produced as a sample, and a reliability of the sample is examined.

A sample of an organic electroluminescence light emitting device was prepared in the same manner as that described in Example 1. Namely, like Example 1, a mixed layer made from the same styryl compound 1 as that described in Example 1 and the same electron transport material $Alq_3$ as that described in Example 1 was formed as a light emission layer by a vacuum vapor-deposition process. The same sample No. Device (1-3) as that prepared in Example 1 was thus prepared.

The sample thus prepared was left in a nitrogen atmosphere for one month, the result of which showed that no deterioration of the sample was observed. The sample was also forcibly deteriorated by continuously applying a constant current thereto with an initial luminance set to 1,000 cd/m$^2$ so as to continuously emit light, the result of which showed that the half value period of luminance was 1,000 hours.

Example 10 (Stability of Device (3-3))

In this example, an organic electroluminescence light emitting device using, as a light emission layer having an electron transport characteristic, a mixed layer made from the same styryl compound 2 as that described in Example 3 and the same electron transport material $Alq_3$ as that described in Example 3 is produced as a sample, and a reliability of the sample is examined.

A sample of an organic electroluminescence light emitting device was prepared in the same manner as that described in Example 3. Namely, like Example 3, a mixed layer made from the same styryl compound 2 as that described in Example 3 and the same electron transport material $Alq_3$ as that described in Example 3 was formed as a light emission layer by a vacuum vapor-deposition process. The same sample No. Device (3-3) as that prepared in Example 3 was thus prepared.

The sample thus prepared was left in a nitrogen atmosphere for one month, the result of which showed that no deterioration of the sample was observed. The sample was also forcibly deteriorated by continuously applying a constant current thereto with an initial luminance set to 1,000 cd/m$^2$ so as to continuously emit light, the result of which showed that the half value period of luminance was 4,800 hours.

Example 11 (Device Using Mixed Layer Made of Compound 3 and $Alq_3$ as Light Emission Layer Having Electron Transport Characteristic)

In this example, organic electroluminescence light emitting devices, each using, as a light emission layer having an electron transport characteristic, a mixed layer made from a styryl compound represented by a compound 3 expressed by the following chemical formula and the same electron transport material $Alq_3$ as that described in Example 1, are produced as samples, and device characteristics of each sample are examined.

[Compound 3]:

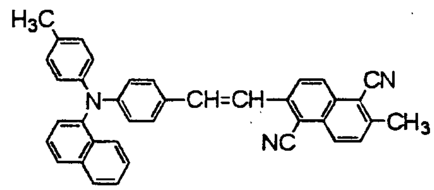

Samples of organic electroluminescence light emitting devices were prepared in the same manner as that for preparing the sample Nos. Device (1-1) to Device (1-5) in Example 1, except that a mixed layer made from a styryl compound represented by a compound 3 having the above chemical formula and the same electron transport material $Alq_3$ as that described in Example 1 was formed as a light emission layer by a vacuum vapor-deposition process. Five sample Nos. Device (11-1), (11-2), (11-3), (11-4), and (11-5) containing 10 wt%, 30 wt%, 50 wt%, 80 wt%, and 90 wt% of the compound 3 in the mixed layer, respectively were thus prepared.

Each of the five samples emitted light of red, and exhibited a high luminous efficiency in a practical luminance region from 10 to 1,000 cd/$m^2$. Also, it was revealed that the sample did not exhibit any change in hue with an increase in luminance, and therefore, the sample was useful as a display device.

Each of the samples thus prepared was left in a nitrogen atmosphere for one month, the result of which showed that no deterioration of the sample was observed. Of these samples, the sample No. Device (11-3) was also forcibly deteriorated by continuously applying a constant current thereto with an initial luminance set to 1,000 cd/$m^2$ so as to continuously emit light, the result of which showed that the half value period of luminance was 1,200 hours.

Example 12 (Device Using Mixed Layer Made from Compound 4 and $Alq_3$ as Light Emission Layer Having Electron Transport Characteristic)

In this example, organic electroluminescence light emitting devices, each using, as a light emission layer having an electron transport characteristic, a mixed layer made from a styryl compound represented by a compound 4 expressed by the following chemical formula and the same electron transport material $Alq_3$ as that described in Example 1, are produced as samples, and device characteristics of each sample are examined.

[Compound 4]:

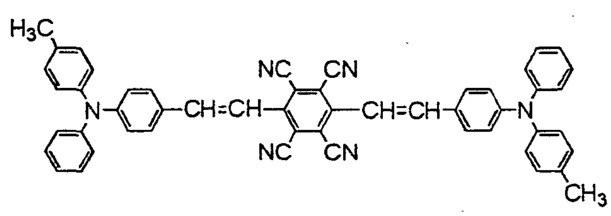

Samples of organic electroluminescence light emitting devices were prepared in the same manner as that for preparing the sample Nos. Device (1-1) to Device (1-5) in Example 1, except that a mixed layer made from a styryl compound represented by a compound 4 having the above chemical formula and the same electron transport material $Alq_3$ as that described in Example 1 was formed as a light emission layer by a vacuum vapor-deposition process. Five sample Nos. Device (12-1), (12-2), (12-3), (12-4), and (12-5) containing 10 wt%, 30 wt%, 50 wt%, 80 wt%, and 90 wt% of the compound 4 in the mixed layer, respectively were thus prepared.

Each of the five samples emitted light of green, and exhibited a high luminous efficiency in a practical luminance region from 10 to 1,000 cd/$m^2$. Also, it was revealed that the sample did not exhibit any change in hue with an increase in luminance, and therefore, the sample was useful as a display device.

Each of the samples thus prepared was left in a nitrogen atmosphere for one month, the result of which showed that no deterioration of the sample was observed. Of these samples, the sample No. Device (12-3) was also forcibly deteriorated by continuously applying a constant current thereto with an initial luminance set to 1,000 cd/$m^2$

so as to continuously emit light, the result of which showed that the half value period of luminance was 500 hours.

Example 13 (Device Using Mixed Layer Made from Compound 5 and α-NPD as Light Emission Layer Having Hole Transport Characteristic)

In this example, organic electroluminescence light emitting devices, each using, as a light emission layer having a hole transport characteristic, a mixed layer made from a styryl compound represented by a compound 5 expressed by the following chemical formula and the same hole transport material α-NPD as that described in Example 2, are produced as samples, and device characteristics of each sample are examined.

[Compound 5]:

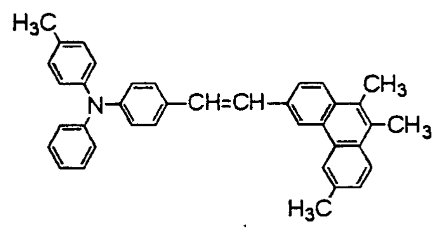

Samples of organic electroluminescence light emitting devices were prepared in the same manner as that for preparing the sample Nos. Device (2-1) to Device (2-5) in Example 2, except that a mixed layer made from a styryl compound represented by a compound 5 having the above chemical formula and the same hole transport material α-NPD as that described in Example 2 was formed as a light emission layer by a vacuum vapor-deposition process.. Five sample Nos. Device (13-1), (13-2), (13-3), (13-4), and (13-5) containing 10 wt%, 30 wt%, 50 wt%, 80 wt%, and 90 wt% of the compound 5 in the mixed layer, respectively were thus prepared.

Each of the five samples emitted light of blue-green, and exhibited a high luminous efficiency in a practical luminance region from 10 to 500 $cd/m^2$. Also, it was revealed that the sample did not exhibit any change in hue with an increase in luminance, and therefore, the sample was useful as a display device.

Each of the samples thus prepared was left in a nitrogen atmosphere for one month, the result of which showed that no deterioration of the sample was observed. Of these samples, the sample No. Device (13-3) was also forcibly deteriorated by continuously applying a constant current thereto with an initial luminance set to 500 $cd/m^2$ so as to continuously emit light, the result of which showed that the half value period of luminance was 800 hours.

Example 14 (Device Using Mixed Layer Made from Compound 6 and α-NPD as Light Emission Layer having Hole Transport Characteristic)

In this example, organic electroluminescence light emitting devices, each using, as a light emission layer having a hole transport characteristic, a mixed layer made from a compound 6 expressed by the following chemical formula and the same hole transport material α-NPD as that described in Example 2 and the like, are produced as samples, and device characteristics of each sample are examined.

[Compound 6]:

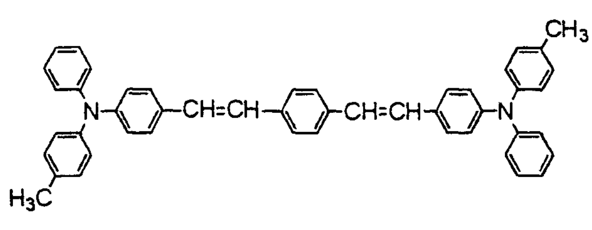

Samples of organic electroluminescence light emitting devices were prepared by forming the following layer structures on an ITO substrate by a vacuum vapor-deposition process. As a feature of this example, a second electron transport layer made from BAlq (bis (8-quinolinol) aluminum derivative) expressed by the following chemical formula was additionally formed between the light emission layer and the electron transport layer.

[BAlq] :

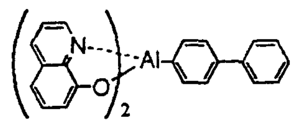

[Device Structure]:

Device (14-1):
ITO/α-NPD [30 nm]/compound 6: α-NPD = 1:9 [30 nm]/BAlq [10 nm]/$Alq_3$ [30 nm]/Mg:Ag [200 nm]
Device (14-2):
ITO/α-NPD [30 nm]/compound 6: α-NPD = 3:7 [30 nm]/BAlq [10 nm]/$Alq_3$ [30 nm]/Mg:Ag [200 nm]
Device (14-3):
ITO/α-NPD [30 nm]/compound 6: α-NPD = 5:5 [30 nm]/BAlq [10 nm]/$Alq_3$ [30 nm]/Mg:Ag [200 nm]
Device (14-4):
ITO/α-NPD [30 nm]/compound 6: α-NPD = 8:2 [30 nm]/BAlq [10 nm]/$Alq_3$ [30 nm]/Mg:Ag [200 nm]
Device (14-5):
ITO/α-NPD [30 nm]/compound 6: α-NPD = 9:1 [30 nm]/BAlq [10 nm]/$Alq_3$ [30 nm]/Mg:Ag [200 nm]

Each of the five samples emitted light of blue-green, and exhibited a high luminous efficiency in a practical luminance region from 10 to 500 $cd/m^2$. Also, it was revealed that the sample did not exhibit any change in hue with an increase in luminance, and therefore, the sample was useful as a display device.

Each of the samples thus prepared was left in a nitrogen atmosphere for one month, the result of which showed that no deterioration of the sample was observed. Of these samples, the sample No. Device (14-3) was also forcibly deteriorated by continuously applying a constant current thereto with an initial luminance set to 500 $cd/m^2$ so as to continuously emit light, the result of which showed that the half value period of luminance was 700 hours.

Example 15 (Device Using Mixed Layer Made from Compound 7 and α-NPD as Light Emission Layer Having Hole Transport Characteristic)

In this example, organic electroluminescence light emitting devices, each using, as a light emission layer having a hole transport characteristic, a mixed layer made from a compound 7 expressed by the following chemical formula and the same hole transport material α-NPD as that described in Example 14, are produced as samples, and device characteristics of each sample are examined.

[Compound 7]:

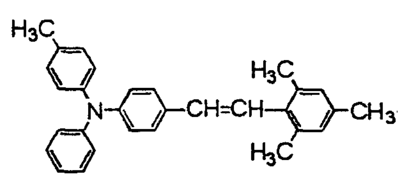

Samples of organic electroluminescence light emitting devices were prepared in the same manner as that for

preparing the sample Nos. Device (14-1) to Device (14-5) in Example 14, except that a mixed layer made from a compound 7 having the above chemical formula and the same hole transport material α-NPD as that described in Example 14 was formed as a light emission layer by a vacuum vapor-deposition process. Five sample Nos. Device (15-1), (15-2), (15-3), (15-4), and (15-5) containing 10 wt%, 30 wt%, 50 wt%, 80 wt%, and 90 wt% of the compound 7 in the mixed layer, respectively were thus prepared.

Each of the five samples emitted light of blue, and exhibited a high luminous efficiency in a practical luminance region from 10 to 500 cd/$m^2$. Also, it was revealed that the sample did not exhibit any change in hue with an increase in luminance, and therefore, the sample was useful as a display device.

Each of the samples thus prepared was left in a nitrogen atmosphere for one month, the result of which showed that no deterioration of the sample was observed. Of these samples, the sample No. Device (15-3) was also forcibly deteriorated by continuously applying a constant current thereto with an initial luminance set to 500 cd/$m^2$ so as to continuously emit light, the result of which showed that the half value period of luminance was 600 hours.

Example 16 (Device Using Mixed Layer Made from Compound 8 and α-NPD as Light Emission Layer Having Hole Transport Characteristic)

In this example, organic electroluminescence light emitting devices, each using, as a light emission layer having a hole transport characteristic, a mixed layer made from a compound 8 expressed by the following chemical formula and the same hole transport material α-NPD as that described in Example 14, are produced as samples, and device characteristics of each sample are examined.

[Compound 8]:

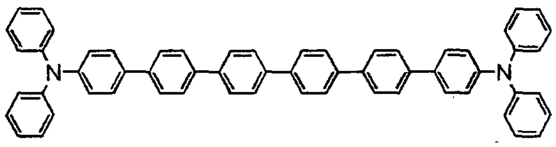

Samples of organic electroluminescence light emitting devices were prepared in the same manner as that for preparing the sample Nos. Device (14-1) to Device (14-5) in Example 14, except that a mixed layer made from a compound 8 having the above chemical formula and the same hole transport material α-NPD as that described in Example 14 was formed as a light emission layer by a vacuum vapor-deposition process. Five sample Nos. Device (16-1), (16-2), (16-3), (16-4), and (16-5) containing 10 wt%, 30 wt%, 50 wt%, 80 wt%, and 90 wt% of the compound 8 in the mixed layer, respectively were thus prepared.

Each of the five samples emitted light of blue, and exhibited a high luminous efficiency in a practical luminance region from 10 to 500 cd/$m^2$. Also, it was revealed that the sample did not exhibit any change in hue with an increase in luminance, and therefore, the sample was useful as a display device.

Each of the samples thus prepared was left in a nitrogen atmosphere for one month, the result of which showed that no deterioration of the sample was observed. Of these samples, the sample No. Device (16-3) was also forcibly deteriorated by continuously applying a constant current thereto with an initial luminance set to 500 cd/$m^2$ so as to continuously emit light, the result of which showed that the half value period of luminance was 750 hours.

Example 17 (Device Using Mixed Layer Made from Compound 9 and CBP as Light Emission Layer)

In this example, organic electroluminescence light emitting devices, each using, as a light emission layer, a mixed layer made from a compound 9 expressed by the following chemical formula and CBP (4,4'-N,N'-dicarbazole-biphenyl) expressed by the following chemical formula, are produced as samples, and device characteristics of each sample are examined.

[Compound 9]:

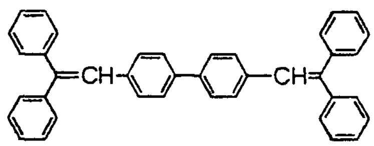

[CBP] :

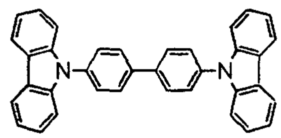

Samples of organic electroluminescence light emitting devices were prepared in the same manner as that for preparing the sample Nos. Device (1-1) to Device (1-5) in Example 1, except that a mixed layer made from a compound 9 having the above chemical formula and CBP having the above chemical formula was formed as a light emission layer by a vacuum vapor-deposition process. Five sample Nos. Device (17-1), (17-2), (17-3), (17-4), and (17-5) containing 10 wt%, 30 wt%, 50 wt%, 80 wt%, and 90 wt% of the compound 9 in the mixed layer, respectively were thus prepared.

Each of the five samples emitted light of blue, and exhibited a high luminous efficiency in a practical luminance region from 10 to 500 cd/$m^2$. Also, it was revealed that the sample did not exhibit any change in hue with an increase in luminance, and therefore, the sample was useful as a display device.

Each of the samples thus prepared was left in a nitrogen atmosphere for one month, the result of which showed that no deterioration of the sample was observed. Of these samples, the sample No. Device (17-3) was also forcibly deteriorated by continuously applying a constant current thereto with an initial luminance set to 500 cd/$m^2$ so as to continuously emit light, the result of which showed that the half value period of luminance was 780 hours.

Example 18 (Device Using Mixed Layer Made from Compound 10 and CBP as Light Emission Layer)

In this example, organic electroluminescence light emitting devices, each using, as a light emission layer, a mixed layer made from a compound 10 expressed by the following chemical formula and the same material CBP as that described in Example 17, are produced as samples, and device characteristics of each sample are examined.

[Compound 10]:

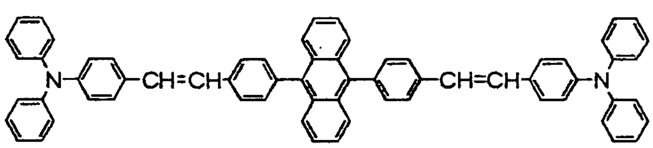

Samples of organic electroluminescence light emitting devices were prepared in the same manner as that for preparing the sample Nos. Device (1-1) to Device (1-5) in Example 1, except that a mixed layer made from a compound 10 having the above chemical formula and the same material CBP as that described in Example 17 was formed as a light emission layer by a vacuum vapor-deposition process. Five sample Nos. Device (18-1), (18-2), (18-3), (18-4), and (18-5) containing 10 wt%, 30 wt%, 50 wt%, 80 wt%, and 90 wt% of the compound 10 in the mixed layer, respectively were thus prepared.

Each of the five samples emitted light of blue green, and exhibited a high luminous efficiency in a practical luminance region from 10 to 500 cd/$m^2$. Also, it was revealed that the sample did not exhibit any change in hue with an increase in luminance, and therefore, the sample was useful as a display device.
Each of the samples thus prepared was left in a nitrogen atmosphere for one month, the result of which showed that no deterioration of the sample was observed. Of these samples, the sample No. Device (18-3) was also forcibly deteriorated by continuously applying a constant current thereto with an initial luminance set to 500 cd/$m^2$ so as to continuously emit light, the result of which showed that the half value period of luminance was 1,100 hours.

Example 19 (Device Using Mixed Layer Made from Compound 11 and CBP as Light Emission Layer)

In this example, organic electroluminescence light emitting devices, each using, as a light emission layer, a mixed layer made from a compound 11 expressed by the following chemical formula and the same material CBP as that described in Example 17, are produced as samples, and device characteristics of each sample are examined.

[Compound 11]:

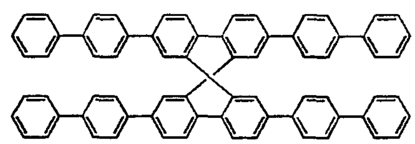

Samples of organic electroluminescence light emitting devices were prepared in the same manner as that for preparing the sample Nos. Device (1-1) to Device (1-5) in Example 1, except that a mixed layer made from a compound 11 having the above chemical formula and the same material CBP as that described in Example 17 was formed as a light emission layer by a vacuum vapor-deposition process. Five sample Nos. Device (19-1), (19-2), (19-3), (19-4), and (19-5) containing 10 wt%, 30 wt%, 50 wt%, 80 wt%, and 90 wt% of the compound 11 in the mixed layer, respectively were thus prepared.
Each of the five samples emitted light of blue, and exhibited a high luminous efficiency in a practical luminance region from 10 to 500 cd/$m^2$. Also, it was revealed that the sample did not exhibit any change in hue with an increase in luminance, and therefore, the sample was useful as a display device.
Each of the samples thus prepared was left in a nitrogen atmosphere for one month, the result of which showed that no deterioration of the sample was observed. Of these samples, the sample No. Device (19-3) was also forcibly deteriorated by continuously applying a constant current thereto with an initial luminance set to 500 cd/$m^2$ so as to continuously emit light, the result of which showed that the half value period of luminance was 650 hours.

Example 20 (Device Using Mixed Layer Made from Compound 12 and CBP as Light Emission Layer)

In this example, organic electroluminescence light emitting devices, each using, as a light emission layer, a mixed layer made from a compound 12 expressed by the following chemical formula and the same material CBP as that described in Example 17, are produced as samples, and device characteristics of each sample are examined.

[Compound 12]:

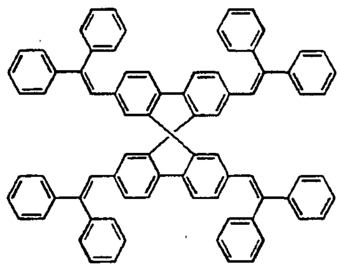

Samples of organic electroluminescence light emitting devices were prepared in the same manner as that for preparing the sample Nos. Device (1-1) to Device (1-5) in Example 1, except that a mixed layer made from a compound 12 having the above chemical formula and the same material CBP as that described in Example 17 was formed as a light emission layer by a vacuum vapor-deposition process. Five sample Nos. Device (20-1), (20-2), (20-3), (20-4), and (20-5) containing 10 wt%, 30 wt%, 50 wt%, 80 wt%, and 90 wt% of the compound 12 in the mixed layer, respectively were thus prepared.

Each of the five samples emitted light of blue, and exhibited a high luminous efficiency in a practical luminance region from 10 to 500 cd/$m^2$. Also, it was revealed that the sample did not exhibit any change in hue with an increase in luminance, and therefore, the sample was useful as a display device.

Each of the samples thus prepared was left in a nitrogen atmosphere for one month, the result of which showed that no deterioration of the sample was observed. Of these samples, the sample No. Device (20-3) was also forcibly deteriorated by continuously applying a constant current thereto with an initial luminance set to 500 cd/$m^2$ so as to continuously emit light, the result of which showed that the half value period of luminance was 880 hours.

Comparative Example 1 (Hue and Reliability of Light Emitting Device Using Single Layer of Compound 1 as Light Emission Layer)

In this comparative example, a sample of an organic electroluminescence light emitting device was produced in the same manner as that described in Example 1, except that a single layer of 100% of the styryl compound 1 described in Example 1 was used as a light emission layer, and a reliability of the sample was examined.

[Device Structure]:

Device (1-6):
ITO/$\alpha$-NPD [30 nm]/compound 1 [30 nm]/ $Alq_3$ (30 nm)/Mg:Ag [200 nm]

As shown in Table 9, the hue of the sample No. Device (1-6) is nearly equal to each of the sample Nos. Device (1-1), Device (1-2), Device (1-3), Device (1-4), and Device (1-5) prepared in Example 5.

Table 9

| (Relationship between Concentration of Compound 1 in Light Emission Layer and Hue in Comparative Example 1) | | | | | |
|---|---|---|---|---|---|
| | Concentration of Compound 1 | 1 cd/$m^2$ | 10 cd/$m^2$ | 100 cd/$m^2$ | 1000 cd/$m^2$ |
| Device (1-6) | 100 wt% | 0.633, 0.367 | 0.632, 0.366 | 0.632, 0.366 | 0.628, 0.371 |

The sample No. Device (1-6) thus prepared was left in a nitrogen atmosphere for one month, the result of which showed that no deterioration of the sample was observed, and it was also forcibly deteriorated by continuously applying a constant current thereto with an initial luminance set to 1,000 cd/$m^2$ so as to continuously emit light, the result of which showed that the half value period of luminance was 200 hours. This half value life is about one-fifth of the half value life (1,000 hr) of the sample No. Device (1-3) prepared in Example 9.

Comparative Example 2 (Hue and Reliability of Light Emitting Device Using Single Layer of Compound 2 as Light Emission Layer)

In this comparative example, a sample of an organic electroluminescence light emitting device was produced in the same manner as that described in Example 3, except that a single layer of 100% of the styryl compound 2 described in Example 3 was used as a light emission layer, and a reliability of the sample was examined.

[Device Structure]:

Device (3-6):
ITO/α-NPD [30 =]/compound 2 [30 nm]/ $Alq_3$ [30 nm]/Mg:Ag [200 nm]

As shown in Table 10, the hue of the sample No. Device (3-6) is nearly equal to each of the sample Nos. Device (3-1), Device (3-2), Device (3-3), Device (3-4), and Device (3-5) prepared in Example 7.

Table 10

(Relationship between Concentration of Compound 2 in Light Emission Layer and Hue in Comparative Example 2)

| | Concentration of Compound 2 | 1 cd/$m^2$ | 10 cd/$m^2$ | 100 cd/$m^2$ | cd/$m^2$ |
|---|---|---|---|---|---|
| Device (3-6) | 100 wt% | 0.648, 0.351 | 0.647, 0.352 | 0.646, 0.353 | 1000 0.641, 0.358 |

The sample No. Device (3-6) thus prepared was left in a nitrogen atmosphere for one month, the result of which showed that no deterioration of the sample was observed, and it was also forcibly deteriorated by continuously applying a constant current thereto with an initial luminance set to 1,000 cd/$m^2$ so as to continuously emit light, the result of which showed that the half value period of luminance was 800 hours. This half value life is about one-sixth of the half value life (4,800 hr) of the sample No. Device (3-3) prepared in Example 10.

Example 21 (Relationship between Concentration of Luminous Material and Device Resistance)

In this example, organic electroluminescence light emitting devices, each using, as a light emission layer having an electron transport characteristic, a mixed layer made from the same styryl compound 1 as that described in Example 1 and the same electron transport material $Alq_3$ as that described in Example 1, are produced as samples, and a relationship between a concentration of the compound 1 and a current density/voltage of each sample is examined.

Samples of organic electroluminescence light emitting devices were prepared in the same manner as that described in Example 1, except that a mixed layer made from the same styryl compound 1 as that described in Example 1 and the same electron transport material $Alq_3$ as that described in Example 1 was formed as a light emission layer by a vacuum vapor-deposition process. Sample Nos. Device (21-1), Device (21-2), Device (21-3), Device (21-4), and Device (21-5) were thus prepared.

The results are shown in Table 11. For comparison, the result of an organic electroluminescence light emitting device, which was prepared in the same manner except the use of a layer composed of only the compound 1 as the light emission layer, is listed as sample No. Device (21-5) in Table 11.

Table 11

(Relationship between Concentration of Compound 1 in Light Emission Layer and Device Resistance)

| | Concentration of Compound 1 | 6V | 10V |
|---|---|---|---|
| Device (21-1) | 5 wt% | 3.7 mA/$cm^2$ | 216 mA/$cm^2$ |
| Device (21-2) | 10 wt% | 11.7 mA/$cm^2$ | 607 mA/$cm^2$ |
| Device (21-3) | 20 wt% | 15.7 mA/$cm^2$ | 1007 mA/$cm^2$ |
| Device (21-4) | 40 wt% | 19.2 mA/$cm^2$ | 1320 mA/$cm^2$ |
| Device (21-5) | 100 wt% | 30.0 mA/$cm^2$ | 1810 mA/$cm^2$ |

As shown in Table 11, it becomes apparent that the device resistance increases with a decrease in concentration of the compound 1. Taking into account a low voltage drive from the viewpoint of power consumption, the concentration of the compound 1 in the light emission layer is desirable to be in a range of 20 wt% or more.

Example 22 (Concentration of Compound 1, Luminous Efficiency, and Hue)

In this example, organic electroluminescence light emitting devices, each using, as a light emission layer, a mixed layer made from the styryl compound 1, the hole transport material α-NPD, and the electron transport material Alq3, which are the same as those described in Example 1, are produced as samples, and a relationship between a luminance of light, a luminous efficiency, and a hue of light of each sample is examined.
Samples of organic electroluminescence light emitting devices were prepared in the same manner as that described in Example 1, except that a mixed layer made from the styryl compound 1, the hole transport material α-NPD, and the electron transport material $Alq_3$, was formed as a light emission layer by a vacuum vapor-deposition process.

[Device Structure]:

Device (22-1):
ITO/α-NPD [30 nm]/compound 1:α-NPD: $Alq_3$ = 1:2:2 [30 nm]/$Alq_3$ [30 nm]/Mg:Ag [200 nm]
Device (22-2):
ITO/α-NPD [30 nm]/compound 1:α-NPD: $Alq_3$ = 1:1:1 [30 nm]/$Alq_3$ [30 nm]/Mg:Ag [200 nm]
Device (22-3):
ITO/α-NPD [30 nm]/compound 1:α-NPD: $Alq_3$ = 4:2:2 [30 nm]/$Alq_3$ [30 nm]/Mg:Ag [200 nm]
Device (22-4):
ITO/α-NPD [30 nm]/compound 1:α-NPD: $Alq_3$ = 8:1:1 [30 nm]/$Alq_3$ [30 nm]/Mg:Ag [200 nm]

A relationship between a luminance and a luminous efficiency of each of the sample Nos. Device (22-1), Device (22-2), Device (22-3), and Device (22-4) thus prepared is shown in Table 12. It is to be noted that the luminous efficiency is calculated as a rate of luminance to a current value.

Table 12

(Relationship between Concentration of Compound 1 in Light Emission Layer and Luminous Efficiency)

| | Concentration of Compound 1 in Light Emission Layer | 1 cd/m$^2$ | 10 cd/m$^2$ | 100 cd/m$^2$ | 1000 cd/m$^2$ |
|---|---|---|---|---|---|
| Device (22-1) | 20 wt% | 2.11 cd/A | 2.13 cd/A | 2.23 cd/A | 2.08 cd/A |
| Device (22-2) | 33 wt% | 2.14 cd/A | 2.15 cd/A | 2.11 cd/A | 2.07 cd/A |
| Device (22-3) | 50 wt% | 2.13 cd/A | 2.14 cd/A | 2.10 cd/A | 2.04 cd/A |
| Device (22-4) | 80 wt% | 2.12 cd/A | 2.11 cd/A | 2.06 cd/A | 2.03 cd/A |

The results show that the luminous efficiency of each of the sample Nos. Device (22-1), Device (22-2), Device (22-3), and Device (22-4) is high and stable irrespective of the concentration of the luminescent material in a practical luminance region from 1 to 1000 cd/m$^2$, and that each of the samples has no problem associated with concentration-dependent quenching caused when a high concentration of the luminous material is contained in the light emitting device. Similarly, a relationship between a luminance and a hue of each sample is shown in Table 13.

Table 13

(Relationship between Concentration of Compound 1 in Light Emission Layer and Hue)

| | Concentration of Compound 1 | 1 cd/m$^2$ | 10 cd/m$^2$ | 100 cd/m$^2$ | 1000 cd/m$^2$ |
|---|---|---|---|---|---|
| Device (22-1) | 20 wt% | 0.627, 0.372 | 0.625, 0.374 | 0.624, 0.375 | 0.621, 0.380 |
| Device (22-2) | 33 wt% | 0.631, 0.369 | 0.630, 0.369 | 0.629, 0.370 | 0.627, 0.372 |
| Device (22-3) | 50 wt% | 0.633, 0.366 | 0.632, 0.367 | 0.632, 0.367 | 0.631, 0.368 |

Table 13 (continued)

| (Relationship between Concentration of Compound 1 in Light Emission Layer and Hue) | | | | | |
|---|---|---|---|---|---|
| | Concentration of Compound 1 | 1 $cd/m^2$ | 10 $cd/m^2$ | 100 $cd/m^2$ | 1000 $cd/m^2$ |
| Device (22-4) | 80 wt% | 0.633, 0.366 | 0.633, 0.365 | 0.632, 0.367 | 0.631, 0.368 |

The results show that the hues of the sample Nos. Device (22-1), Device (22-2), Device (22-3), and Device (22-4) are nearly equal to each other irrespective of the concentration of the luminescent material in a practical luminance region from 1 to 1000 $cd/m^2$, and that each of the samples has no problem associated with a change in hue upon high luminance, which problem is liable to be caused for a usual red color light emitting device in which a pigment is doped in $Alq_3$ or the like in a concentration as low as 2 to 3 wt% or less.

Example 23 (Stability of Device (22-3))

In this example, an organic electroluminescence light emitting device using, as a light emission layer, a mixed layer made from the styryl compound 1, the hole transport material $\alpha$-NPD, and the electron transport material $Alq_3$, which are the same as those described in Example 22, is produced as a sample, and a reliability of the sample is examined.

A sample of an organic electroluminescence light emitting device was prepared in the same manner as that described in Example 22. Namely, like Example 22, a mixed layer made from the styryl compound 1, the hole transport material $\alpha$-NPD, and the electron transport material $Alq_3$ was formed as a light emission layer by a vacuum vapor-deposition process. The same sample No. Device (22-3) as that prepared in Example 22 was thus prepared.

The sample thus prepared was left in a nitrogen atmosphere for one month, the result of which showed that no deterioration of the sample was observed. The sample was also forcibly deteriorated by continuously applying a constant current thereto with an initial luminance set to 1,000 $cd/m^2$ so as to continuously emit light, the result of which showed that the half value period of luminance was 950 hours.

Example 24 (Verification 1 of Light Emission Region)

In this example, it is examined whether a light emission region is concentrated in the vicinity of an interface of a light emission layer or dispersed over the whole range of the light emission layer, by measuring a change in intensity of a photoluminescence spectrum (PL spectrum) of a luminescent material before and after reduction in luminance.

For the sample No. Device (3-3) using the mixed layer containing the compound 2 and the electron transport material $Alq_3$ at a mixing weight ratio of 1:1 as the light emission layer in Example 3 and the sample No. Device (3-6) using a single layer containing only the compound 2 as the light emission layer, the intensity of the PL spectrum of the device at the time when the EL luminous intensity thereof was reduced to a half of that in an initial stage was examined. As a result, for the sample No. Device (3-3), when the EL luminous intensity was reduced to a half, the intensity of the PL spectrum was reduced to 50% of the initial luminance. On the contrary, for the sample No. Device (3-6) using the single layer containing only the compound 2 as the light emission layer, when the EL luminous intensity was reduced to a half, the intensity of the PL spectrum was reduced to 70% of the initial luminance. Since the whole range of the light emission layer is optically pumped at the time of measuring the intensity of the PL spectrum, it may be considered that if the luminance of the whole range of the light emission range is reduced along with the electroluminescence (EL), the intensity of the PL spectrum is reduced at the same rate; however, if the luminance of part of the light emission layer is reduced along with electroluminescence (EL), the intensity of the PL spectrum is reduced at a rate smaller than the reduction rate of the EL luminous intensity.

Accordingly, it becomes apparent that for the sample No. Device (3-3), the whole range of the light emission layer almost acts as the light emission region; however, for the sample No. Device (3-6), only part of the light emission layer (interface between organic layers) acts as the light emission region.

The EL spectrum of the sample No. Device (3-6) is shown in FIG. 5. The EL spectrum exhibits the peak value at a wavelength near 650 nm, which indicates the compound 2, and a small peak value at a wavelength near 520 nm, which indicates $Alq_3$. This means that for the sample No. Device (3-6), light emission occurs at an interface between the light emission layer containing only the compound 2 and the electron transport layer $Alq_3$, and the light emission region is concentrated in the vicinity of the interface. On the contrary, from the EL spectrum of the sample No. Device (3-3) shown in FIG. 6, it is apparent that light emission occurs nearly in the whole range of the light emission layer and that no light emission of $Alq_3$ occur.

Example 25 (Verification 2 of Light Emission Region)

To verify the effect of the organic electroluminescence light emitting device of the present invention, as shown in FIG. 7, a device was produced with a film thickness condition that a light interference effect between light emerged from a light emission interface and light reflected from an aluminum electrode 37 weakens light outputted from the device. An ITO electrode 36 (thickness: 119 nm), a TNATA (4,4',4"-tris (2-naphthylphenylamino)triphenylamine) layer 32a (thickness: 40 nm), an EL022 (triphenylamine tetramer) layer 32b (thickness: 50 nm), an $Alq_3$ layer 33 mixed with 40% of the above-described styryl compound 1 (thickness: 50 nm), and an $Alq_3$ layer 34 (thickness: 165 nm) were sequentially stacked, and the aluminum electrode 37 was formed thereon. A relationship between an actually measured emission spectrum of this device and an emission spectrum estimated from a light emission distribution in the light emission layer of the device was examined.

As shown in FIG. 8, it becomes apparent that a light emission distribution 49 in the light emission layer corresponds to an emission spectrum of the device operated at a current density of 0.1 mA/cm$^2$, and a light emission distribution 46 in the light emission layer corresponds to an emission spectrum of the device operated at a current density of 1mA/cm$^2$. The light emission distribution in the light emission layer used for calculation is shown in FIG. 9.

Here, the superimposition of a light ray emitted and directly emerged downwardly and a light ray reflected from Al and then emerged downwardly is performed by using plane-wave approximation. Concretely, a phase difference $\delta$ at the superimposition of the light rays is given by

$$\delta = 2\pi \cdot 2L/\lambda + \Phi$$

where character L is an optical distance between the emission plane and Al, and character $\Phi$ is a phase shift amount due to Al reflection. Accordingly, letting a complex amplitude of the light ray directly emerged be A and a complex reflection coefficient of Al be $\gamma$, a complex amplitude of the superimposed light ray is expressed by the following equation:

$$(1 + \exp(i\delta)\ \gamma)\ A$$

By expressing the real number of this equation, the intensity can be obtained. Further, by integrating the intensity with a luminous intensity distribution in each depth direction and calculating the integrated intensity for each wavelength, a spectrum of the light ray emerged to the outside can be obtained.

According to the above-described result, it is verified that in the light emission layer formed by mixing the luminous material having the charge transport characteristic in the charge injection accelerating material, the emission spectrum exhibits that a distribution of a light emission region having a large luminous intensity occurs at both of the interface between the hole transport layer and the light emission layer and the interface between the electron transport layer and the light emission layer. According to this embodiment, the light emission distribution on the hole transport layer side increases with the increased current density.

The above-described embodiments and the examples according to the present invention may be variously modified without departing from the technical thought of the present invention.

According to the present invention, a light emission region is formed by a mixed layer made from a luminous material exhibiting electroluminescence when a voltage is applied thereto and having a charge transport characteristic and a charge injection accelerating material capable of accelerating injection of charges in the luminous material, and the light emission region exists not only at an interface with an adjacent layer or its vicinity but also over a specific thickness region in the layer thickness direction. Accordingly, a region in which light is emitted is not limited to the above-described interface or its vicinity but is spread in a wide range of the light emission layer. As a result, it is possible to significantly improve the service life of the device. Further, it is possible to prevent the hue of light from being varied depending on the concentration of the luminous material contained in the light emission layer and on an operational condition such as an applied voltage, and hence to stabilize the performance of the device.

## Claims

1. An organic electroluminescence light emitting device, in which an organic layer having a light emission region is provided between an anode and a cathode,
   **characterized in that**
   at least one of layers constituting said organic layer is composed of a mixed layer made from a luminescent material and a charge injection accelerating material, wherein said luminescent material exhibits, in a state held

as a single thin film between said anode and said cathode, electroluminescence light emission when a voltage is applied thereto and has a charge transport characteristic, and said charge injection accelerating material has a charge transport characteristic capable of accelerating injection of charges in said luminescent material; and

said at least one of layers constituting said organic layer has a light emission region existing not only at an interface with an adjacent layer or its vicinity but also over a specific thickness region from said interface or its vicinity in the layer thickness direction.

**2.** An organic electroluminescence light emitting device according to claim 1, wherein said light emission region exists over the whole thickness of said mixed layer.

**3.** An organic electroluminescence light emitting device according to claim 2, wherein on the basis of an intensity of light emitted from each or both of an interface between said mixed layer and an electron transport layer adjacent thereto and an interface between said mixed layer and a hole transport layer adjacent thereto, an intensity of light emitted from a position being equidistant from said both interfaces is in a range of 25% or more.

**4.** An organic electroluminescence light emitting device according to claim 1, wherein a concentration range of said luminous material on the basis of a mole number of said charge injection accelerating material in said mixed layer is in a range of 5 to 90 mole percent.

**5.** An organic electroluminescence light emitting device according to claim 1, wherein when said luminous material is configured as a luminous material having at least an electron transport characteristic, said charge injection accelerating material is configured as a charge injection accelerating material having an electron and/or hole transport characteristic.

**6.** An organic electroluminescence light emitting device according to claim 1, wherein when said luminous material is configured as a luminous material having at least a hole transport characteristic, said charge injection accelerating material is configured as a charge injection accelerating material having a hole and/or electron transport characteristic.

**7.** An organic electroluminescence light emitting device according to claim 1, wherein an energy level of a highest occupied molecular orbital of said charge injection accelerating material is equal to or deeper than that of said luminous material, and/or an energy level of a lowest unoccupied molecular orbital of said charge injection accelerating material is equal to or shallower than that of said luminous material.

**8.** An organic electroluminescence light emitting device according to claim 7, wherein an energy level of a lowest unoccupied molecular orbital of a hole transport layer adjacent to said mixed layer is shallower than that of each of said luminous material and said charge injection accelerating material.

**9.** An organic electroluminescence light emitting device according to claim 7, wherein the same material as an electron transport material forming an electron transport layer adjacent to said mixed layer is used as said charge injection accelerating material.

**10.** An organic electroluminescence light emitting material according to claim 7, wherein the same material as a hole transport material forming a hole transport layer adjacent to said mixed layer is used as said charge injection accelerating material.

**11.** An organic electroluminescence material according to claim 7, wherein both the same material as an electron transport material forming an electron transport layer adjacent to said mixed layer and the same material as a hole transport material forming a hole transport layer adjacent to said mixed layer are used as said charge injection accelerating material.

**12.** A light emitting apparatus using an organic electroluminescence light emitting device described in any one of claims 1 to 11.

**13.** A light emitting apparatus according to claim 12, wherein said light emitting apparatus is configured as a display in which said organic electroluminescence light emitting device is used as at least part of a pixel.

F I G. 1

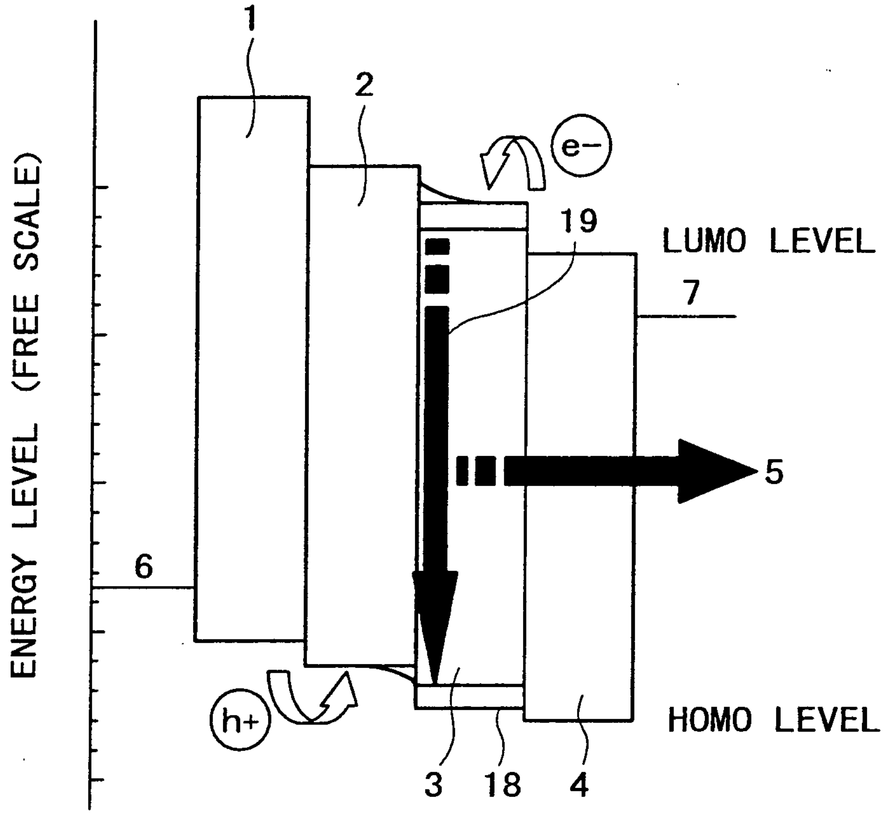
ENERGY LEVEL (FREE SCALE)
1
2
e−
19
LUMO LEVEL
7
5
6
h+
HOMO LEVEL
3
18
4

F I G. 2

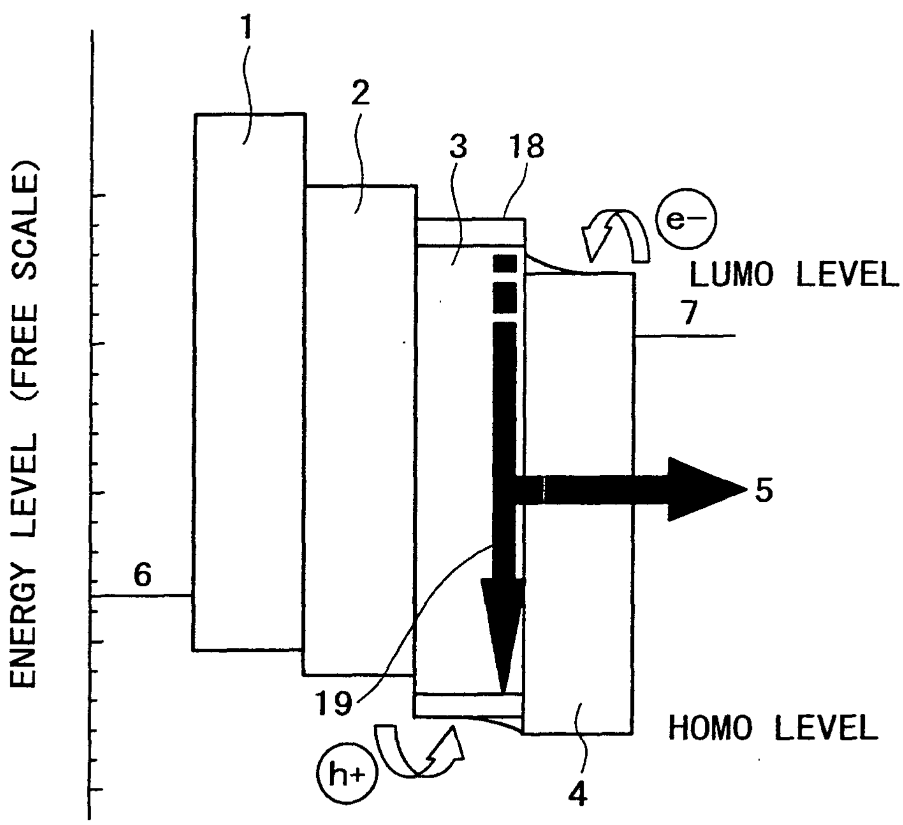
ENERGY LEVEL (FREE SCALE)
1
2
3
18
e−
LUMO LEVEL
7
5
6
19
h+
HOMO LEVEL
4

# F I G. 3

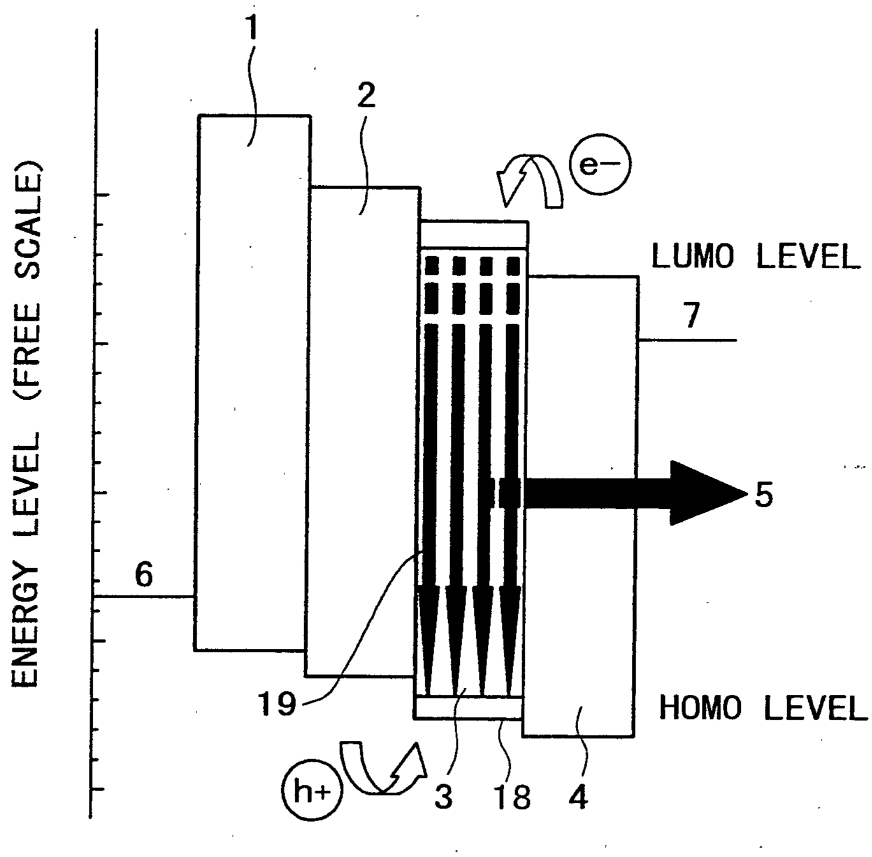
ENERGY LEVEL (FREE SCALE)
1
2
e−
LUMO LEVEL
7
5
6
19
HOMO LEVEL
h+
3
18
4

F I G. 4

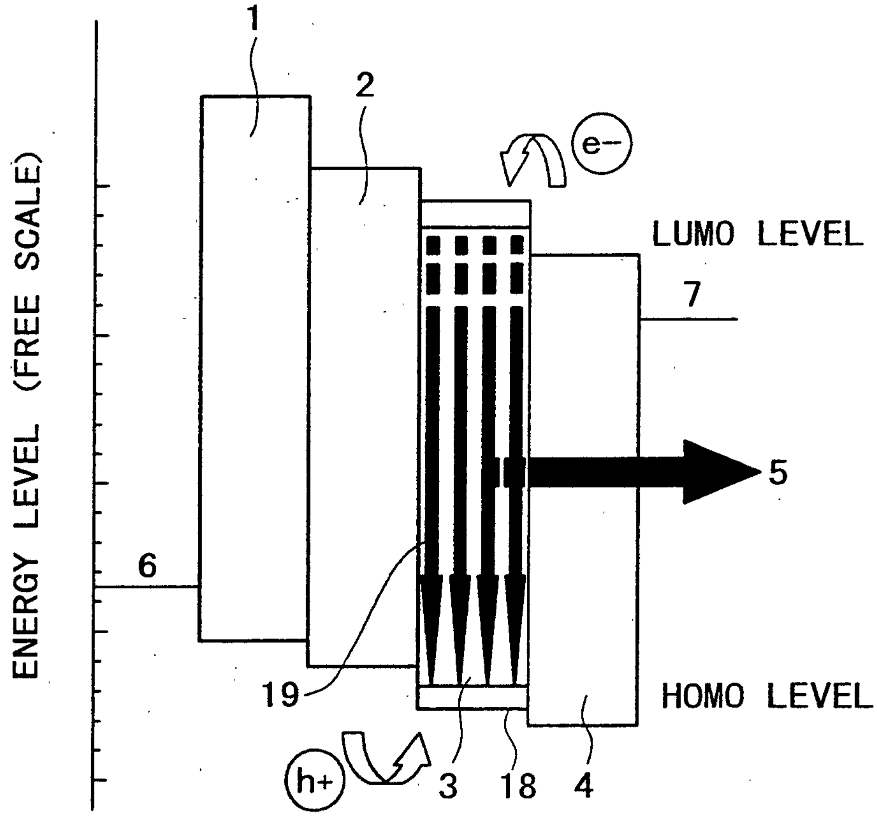
ENERGY LEVEL (FREE SCALE)
1
2
e−
LUMO LEVEL
7
5
6
19
HOMO LEVEL
h+
3
18
4

FIG. 5

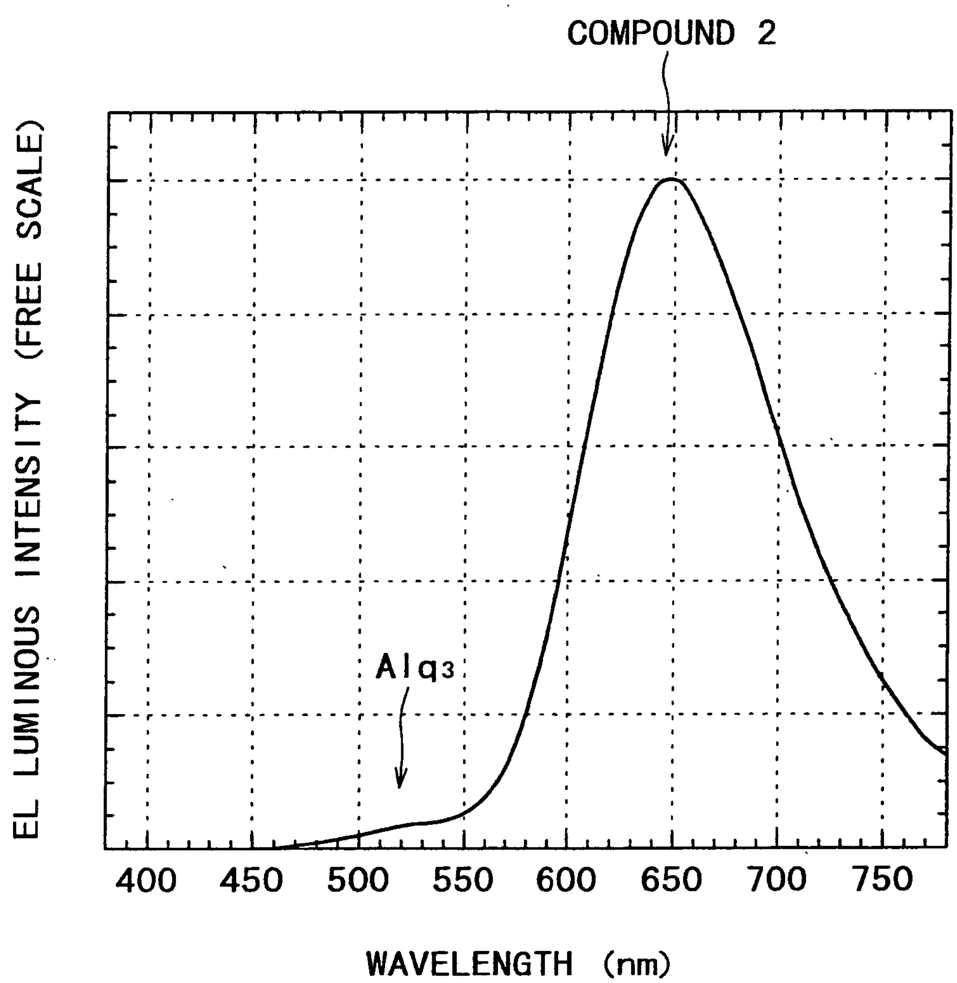
COMPOUND 2
Alq3
EL LUMINOUS INTENSITY (FREE SCALE)
400
450
500
550
600
650
700
750
WAVELENGTH (nm)

# F I G. 6

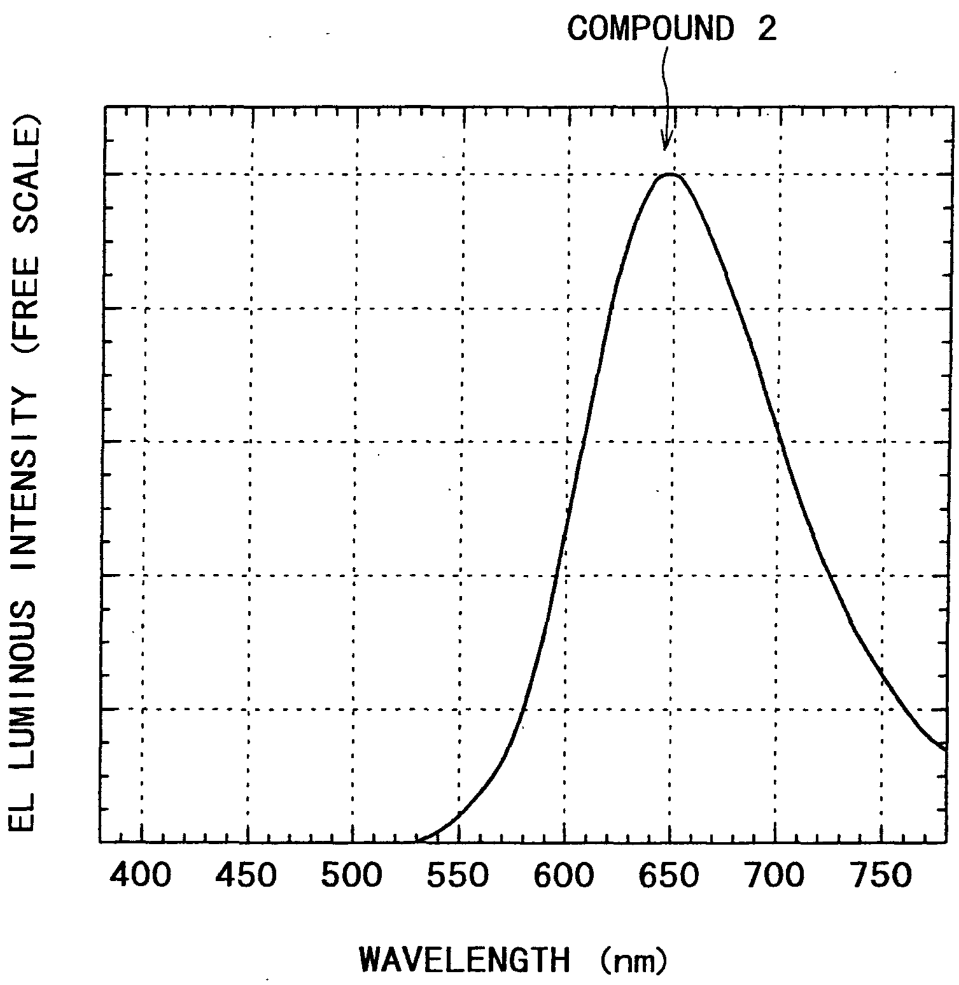
COMPOUND 2
EL LUMINOUS INTENSITY (FREE SCALE)
400
450
500
550
600
650
700
750
WAVELENGTH (nm)

FIG. 7

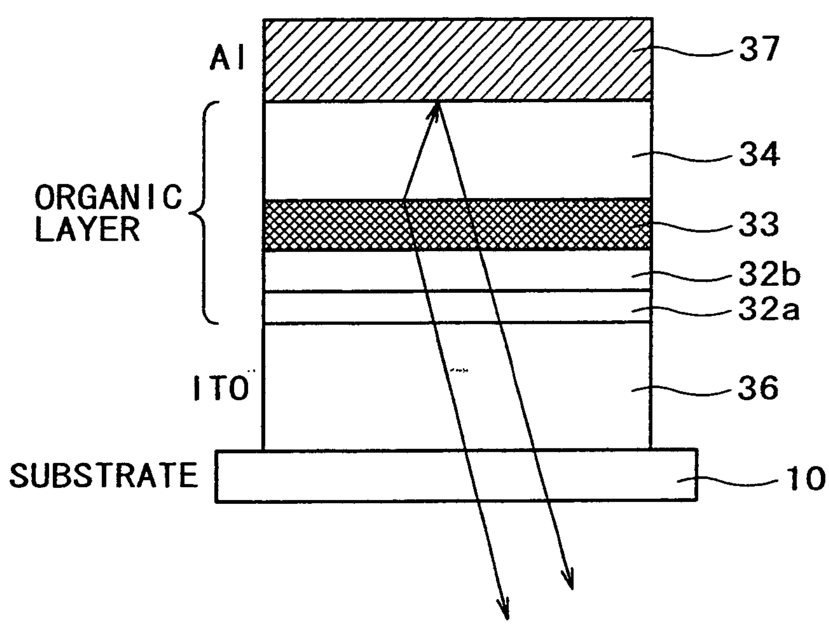

F I G. 8

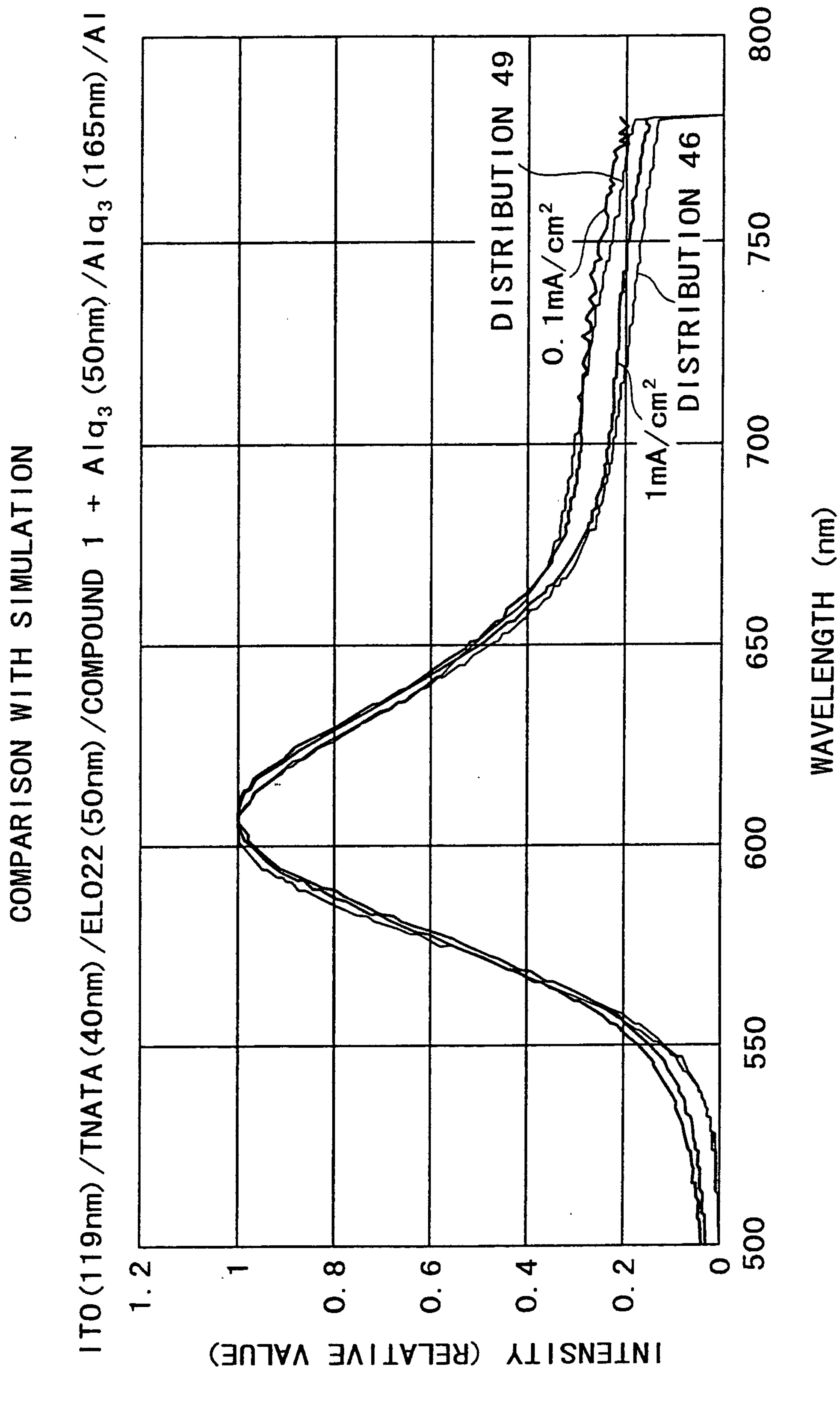
COMPARISON WITH SIMULATION
ITO(119nm)/TNATA(40nm)/EL022(50nm)/COMPOUND 1 + Alq3(50nm)/Alq3(165nm)/Al
INTENSITY (RELATIVE VALUE)
1.2
1
0.8
0.6
0.4
0.2
0
500
550
600
650
700
750
800
WAVELENGTH (nm)
DISTRIBUTION 49
0.1mA/cm2
1mA/cm2
DISTRIBUTION 46

# FIG. 9

DISTRIBUTION CURVE OF LIGHT EMISSION REGION

ITO(119nm)/TNATA(40nm)/EL022(50nm)/COMPOUND 1 + $Alq_3$(50nm)/$Alq_3$(165nm)/Al

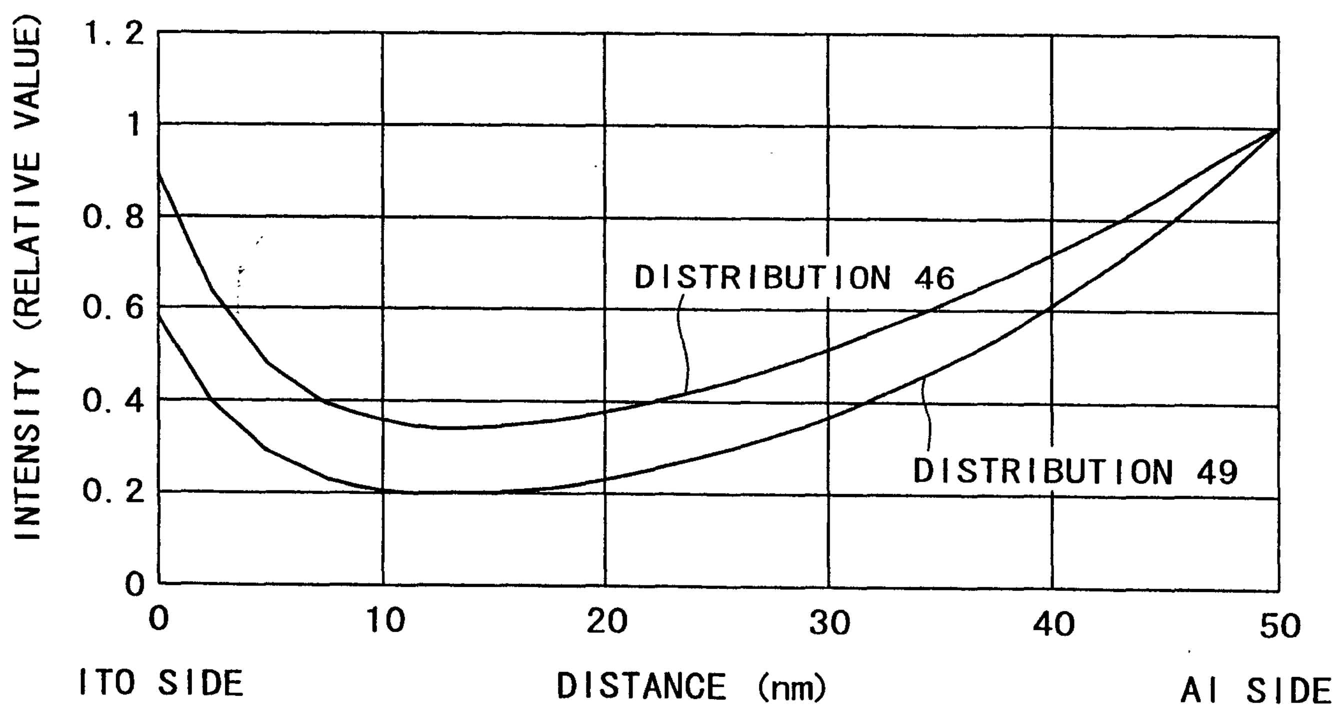

F I G. 1 0

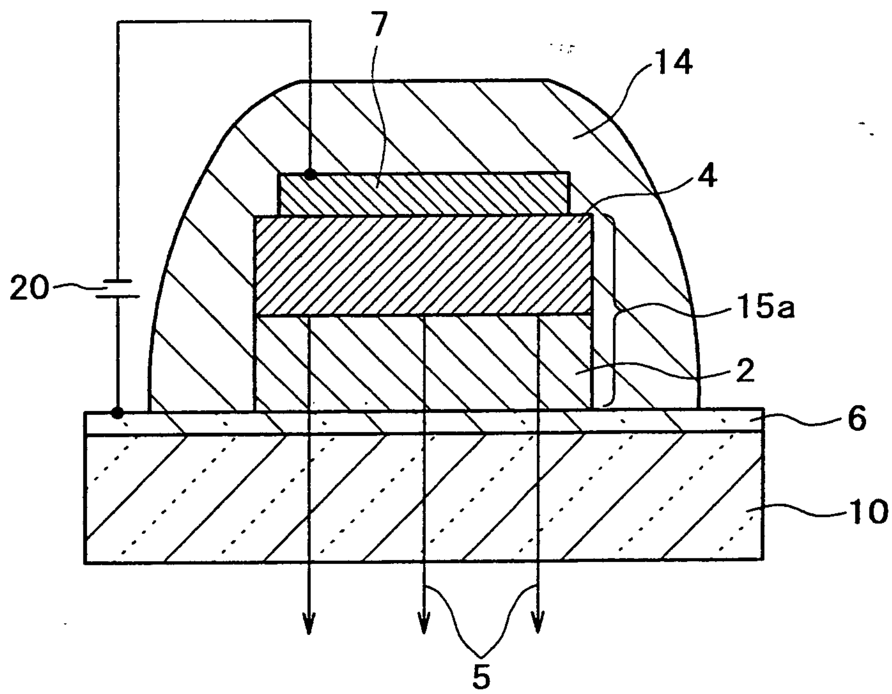

F I G. 1 1

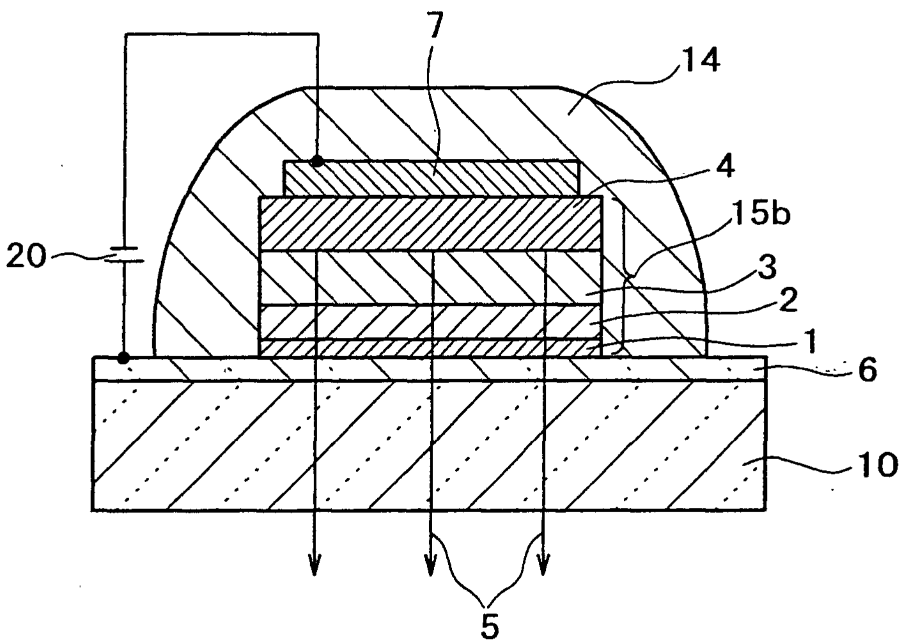

F I G. 1 2

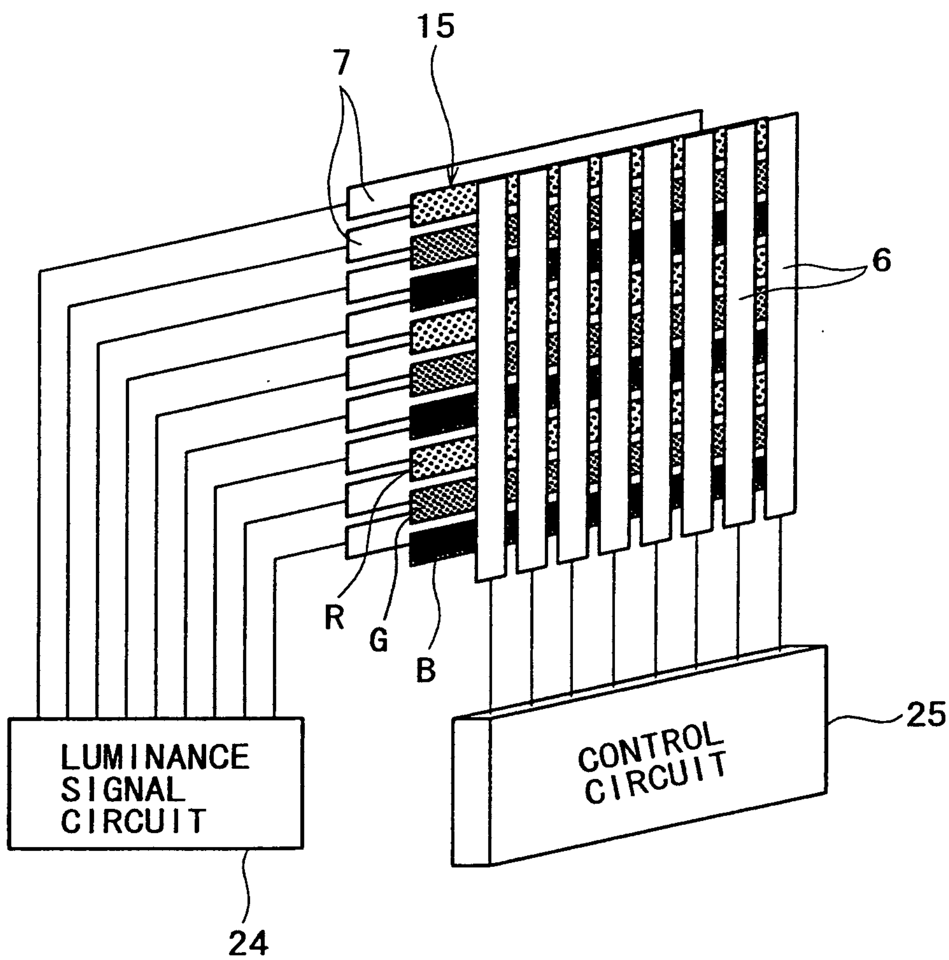

FIG. 13

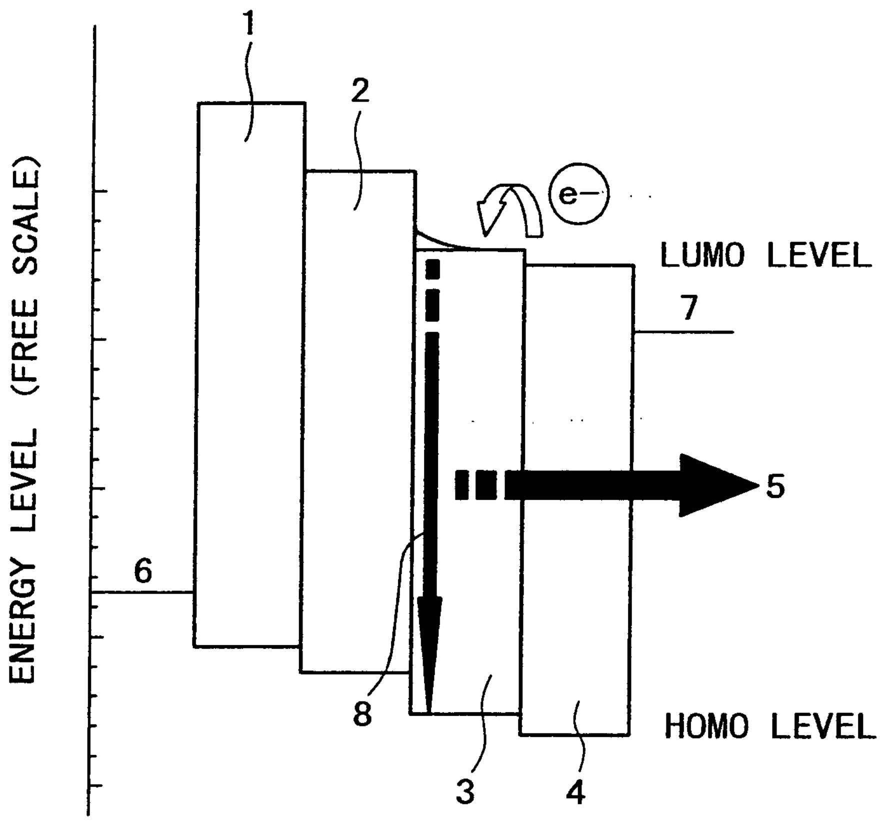

# FIG. 14

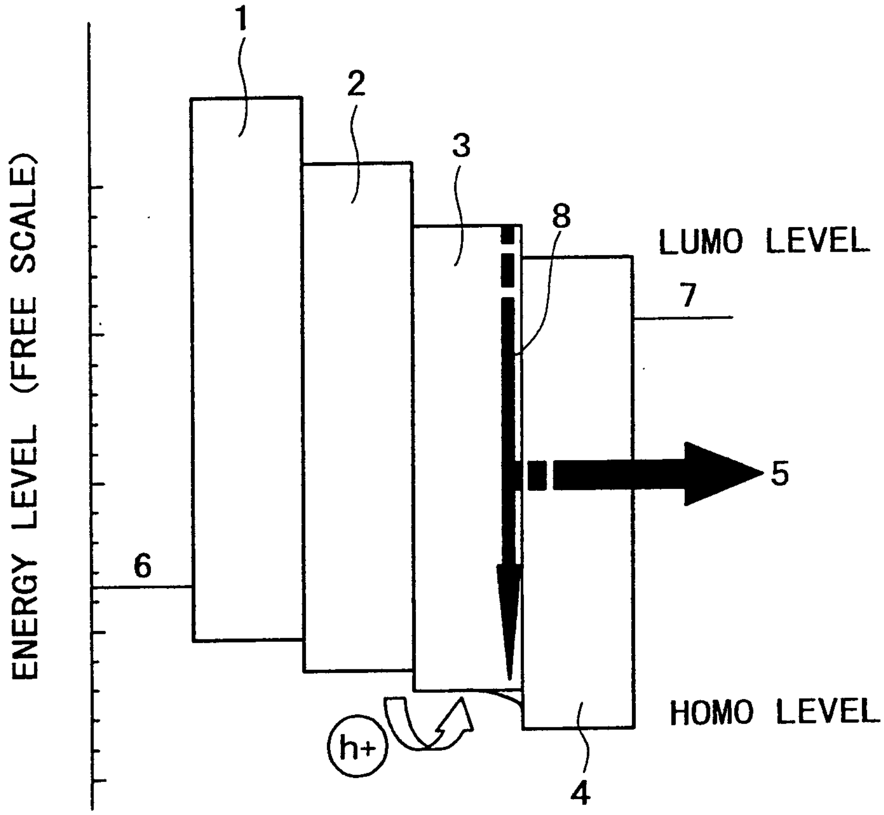

**INTERNATIONAL SEARCH REPORT**

International application No.
PCT/JP02/05366

A. CLASSIFICATION OF SUBJECT MATTER
Int.Cl7 H05B33/14, H05B33/22

According to International Patent Classification (IPC) or to both national classification and IPC

B. FIELDS SEARCHED

Minimum documentation searched (classification system followed by classification symbols)
Int.Cl7 H05B33/00-33/28

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1996-2002 |
| Kokai Jitsuyo Shinan Koho | 1971-2002 | Jitsuyo Shinan Toroku Koho | 1994-2002 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 10-270166 A (Tatsuo MORI, Minolta Co., Ltd.), 09 October, 1998 (09.10.98), Full text; Fig. 1 (Family: none) | 1-13 |
| Y | JP 2001-52870 A (TDK Kabushiki Kaisha), 23 February, 2001 (23.02.01), Claims; page 21, column 39, line 36 to column 40, line 50; page 32, column 61, line 47 to column 62, line 48 (Family: none) | 1-13 |
| Y | JP 2000-12226 A (Sony Corp.), 14 January, 2000 (14.01.00), Claims; page 9, column 15, lines 23 to 27; page 9, column 16, line 46 to page 10, column 17, line 2 & EP 967834 A2 & US 6265088 B1 | 1-13 |

☒ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>20 June, 2002 (20.06.02) | Date of mailing of the international search report<br>02 July, 2002 (02.07.02) |
| Name and mailing address of the ISA/<br>Japanese Patent Office | Authorized officer |
| Facsimile No. | Telephone No. |

Form PCT/ISA/210 (second sheet) (July 1998)

## INTERNATIONAL SEARCH REPORT

International application No.
PCT/JP02/05366

C (Continuation). DOCUMENTS CONSIDERED TO BE RELEVANT

| Category* | Citation of document, with indication, where appropriate, of the relevant passages | Relevant to claim No. |
|---|---|---|
| A | JP 2-250292 A (Ricoh Co., Ltd.), 08 October, 1990 (08.10.90), & US 5085947 A | 1-13 |
| A | JP 2-291696 A (Ricoh Co., Ltd.), 03 December, 1990 (03.12.90), & US 5085946 A | 1-13 |
| A | JP 8-311442 A (TDK Kabushiki Kaisha), 26 November, 1996 (26.11.96), & US 6203933 B1 | 1-13 |

Form PCT/ISA/210 (continuation of second sheet) (July 1998)